# EUROPEAN PATENT APPLICATION

(11) **EP 4 398 285 A1**
(43) Date of publication of application: **10.07.2024**
(21) Application number: 22864366.4
(22) Date of filing: 24.08.2022
(51) Int. Cl.: H01L 21/02, B32B 7/12, C09J 11/06, C09J 183/05, C09J 183/07, H01L 21/304

(54) **ADHESIVE COMPOSITION, MULTILAYER BODY, AND METHOD FOR PRODUCING PROCESSED SEMICONDUCTOR SUBSTRATE**

(30) Priority: 30.08.2021 JP 2021139880
(71) Applicant: Nissan Chemical Corporation, Tokyo 103-6119 (JP)
(72) Inventor: OKUNO, Takahisa, Toyama-shi, Toyama 939-2792 (JP); USUI, Yuki, Toyama-shi, Toyama 939-2792 (JP); YANAI, Masaki, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2022/031855
(87) International publication number: WO 2023/032782

(57) **Abstract**

A laminate including: a semiconductor substrate; a support substrate; and an adhesive layer provided between the semiconductor substrate and the support substrate, wherein
the adhesive layer is formed from a cured product of an adhesive composition,
the adhesive composition contains a polyorganosiloxane that has an alkenyl group having 2 to 40 carbon atoms and bonded to a silicon atom, a polyorganosiloxane having a Si-H group, a platinum group metal-based catalyst, and a crosslinking inhibitor, and
the crosslinking inhibitor contains at least one of a pyridine ring-containing compound and a phosphorus-containing organic compound.

## Description

### Technical Field

The present invention relates to an adhesive composition, a laminate, a method for producing a laminate, and a method for producing a processed semiconductor substrate.

### Background Art

Conventionally, semiconductor wafers have been integrated in a two-dimensional planar direction. For the purpose of further integration, a semiconductor integration technology in which the plane is further integrated (laminated) in a three-dimensional direction has been required. This three-dimensional lamination is a technique of integrating multiple layers while being connected with a through silicon via (TSV). At the time of integrating multiple layers, each wafer to be integrated is thinned by polishing on the side opposite to the formed circuit surface (that is, the back surface), and the thinned semiconductor wafers are laminated.

A semiconductor wafer before thinning (also referred to herein simply as a wafer) is bonded to a support for polishing with a polishing apparatus. The adhesion at this time is referred to as temporary adhesion because it must be easily peeled off after polishing. This temporary adhesion must be easily removed from the support. When a large force is applied to the removal, the thinned semiconductor wafer may be cut or deformed. The removal is easily performed such that the situation does not occur. However, at the time of polishing the back surface of a semiconductor wafer, it is not preferable that the semiconductor wafer is detached or displaced due to polishing stress. Therefore, the performance required for temporary adhesion is to withstand the stress during polishing and to be easily removed after polishing.

As a temporary adhesive used for such temporary adhesion, a temporary adhesive containing a component that cures by a hydrosilylation reaction is used. As the temporary adhesive, for example, a temporary adhesive containing a component (A) that is cured by a hydrosilylation reaction, a polymerization inhibitor (B) having a 5% mass reduction temperature of 80°C or higher in terms of Tg-DTA, and a solvent (C) has been proposed (see Patent Literature 1). In this proposed technique, an acetylenic alcohol such as 1,1-diphenyl-2-propyne-1-ol is used as the polymerization inhibitor (B). The polymerization inhibitor is also called a crosslinking inhibitor.

### Citation List

### Patent Literature

Patent Literature 1: WO 2019/212008 A1

### Summary of Invention

### Technical Problem

When a semiconductor wafer and a support are temporarily bonded to each other using a temporary adhesive, the laminate obtained by bonding the semiconductor wafer and the support to each other using the temporary adhesive may be warped.

When the present inventors used 1,1-diphenyl-2-propyne-1-ol as a crosslinking inhibitor in a temporary adhesive (adhesive composition) using a hydrosilylation reaction, as an example, the laminate obtained using the temporary adhesive had a warpage of 531 um (see Comparative Example 1 in the present description).

A large warpage may cause: a case where the substrate is difficult to convey with a vacuum chuck of a robot arm or the like and thereby the target electronic device cannot be produced; and a case where the electronic device has an increased internal stress caused therein to damage the device.

The present invention has been made in view of the above circumstances, and an object thereof is to provide a laminate capable of reducing warpage as compared with the case of using 1,1-diphenyl-2-propyne-1-ol as a crosslinking inhibitor, a method for producing a processed semiconductor substrate using the laminate, an adhesive composition used for forming an adhesive layer in the laminate, and a method for producing an adhesive layer using the adhesive composition.

### Solution to Problem

As a result of intensive studies to solve the above problems, the present inventors have found that the above problems can be solved, and have completed the present invention having the following gist.

That is, the present invention includes the following.
[1] A laminate including: a semiconductor substrate; a support substrate; and an adhesive layer provided between the semiconductor substrate and the support substrate, wherein
   the adhesive layer is formed from a cured product of an adhesive composition,
   the adhesive composition contains a polyorganosiloxane that has an alkenyl group having 2 to 40 carbon atoms and bonded to a silicon atom, a polyorganosiloxane having a Si-H group, a platinum group metal-based catalyst, and a crosslinking inhibitor, and
   the crosslinking inhibitor contains at least one of a pyridine ring-containing compound and a phosphorus-containing organic compound.
[2] The laminate according to [1], wherein the pyridine ring-containing compound contains a compound represented by the following formula (1), and
   the phosphorus-containing organic compound contains a compound represented by the following formula (2): 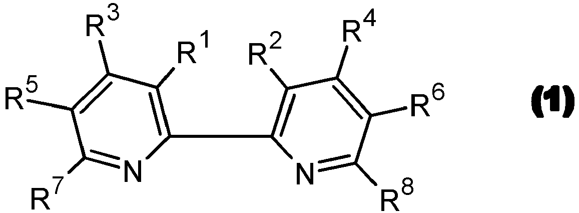
   wherein, in the formula (1), R¹ and R² each independently represent a hydrogen atom or an alkyl group optionally having a substituent, or R¹ and R² are combined with each other to form an aromatic hydrocarbon ring that may have an alkyl group optionally having a substituent, or to form -O-; R³ and R⁴ each independently represent a hydrogen atom or an alkyl group optionally having a substituent; R⁵ and R⁶ each independently represent a hydrogen atom or an alkyl group optionally having a substituent; R⁷ and R⁸ each independently represent a hydrogen atom or an alkyl group optionally having a substituent; R⁵ and R⁷, instead of the above definition, may be combined with each other to form an aromatic hydrocarbon ring that may have an alkyl group optionally having a substituent; and R⁶ and R⁸, instead of the above definition, may be combined with each other to form an aromatic hydrocarbon ring that may have an alkyl group optionally having a substituent; 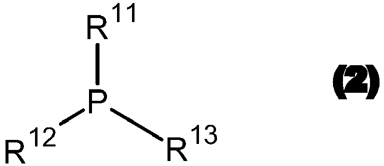
   wherein, in the formula (2), R¹¹ to R¹³ each independently represent a hydrocarbon group optionally having a substituent.
[3] The laminate according to [2], wherein the crosslinking inhibitor contains a compound represented by the formula (1).
[4] The laminate according to [2] or [3], wherein, in the formula (1), R¹, R², R⁷, and R⁸ each represent a hydrogen atom, and R³ to R⁶ each independently represent a hydrogen atom or an alkyl group.
[5] The laminate according to any one of [2] to [4], wherein, in the formula (1), the alkyl groups each independently have 1 to 12 carbon atoms.
[6] The laminate according to [2], wherein the crosslinking inhibitor contains a compound represented by the formula (2).
[7] The laminate according to [2] or [6], wherein, in the formula (2), R¹¹ to R¹³ each independently represent an alkyl group optionally having a substituent or a phenyl group optionally having a substituent.
[8] The laminate according to [7], wherein, in the formula (2), the alkyl groups each independently have 1 to 12 carbon atoms.
[9] A method for producing a processed semiconductor substrate, the method including:
   a first step of processing the semiconductor substrate of the laminate according to any one of [1] to [8]; and
   a second step of separating the semiconductor substrate, which has been processed in the first step, and the support substrate from each other.
[10] An adhesive composition to be used, in a laminate having: a semiconductor substrate; a support substrate; and an adhesive layer provided between the semiconductor substrate and the support substrate, to form the adhesive layer,
   the composition including: a polyorganosiloxane that has an alkenyl group having 2 to 40 carbon atoms and bonded to a silicon atom, a polyorganosiloxane having a Si-H group, a platinum group metal-based catalyst, and a crosslinking inhibitor, wherein
   the crosslinking inhibitor contains at least one of a pyridine ring-containing compound and a phosphorus-containing organic compound.
[11] The adhesive composition according to [10], wherein the pyridine ring-containing compound contains a compound represented by the following formula (1), and
   the phosphorus-containing organic compound contains a compound represented by the following formula (2): 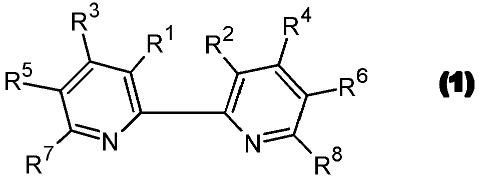
   wherein, in the formula (1), R¹ and R² each independently represent a hydrogen atom or an alkyl group optionally having a substituent, or R¹ and R² are combined with each other to form an aromatic hydrocarbon ring that may have an alkyl group optionally having a substituent, or to form -O-; R³ and R⁴ each independently represent a hydrogen atom or an alkyl group optionally having a substituent; R⁵ and R⁶ each independently represent a hydrogen atom or an alkyl group optionally having a substituent; R⁷ and R⁸ each independently represent a hydrogen atom or an alkyl group optionally having a substituent; R⁵ and R⁷, instead of the above definition, may be combined with each other to form an aromatic hydrocarbon ring that may have an alkyl group optionally having a substituent; and R⁶ and R⁸, instead of the above definition, may be combined with each other to form an aromatic hydrocarbon ring that may have an alkyl group optionally having a substituent; 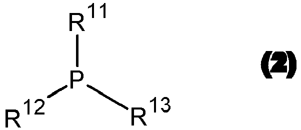
   wherein, in the formula (2), R¹¹ to R¹³ each independently represent a hydrocarbon group optionally having a substituent.
[12] The adhesive composition according to [11], wherein the crosslinking inhibitor contains a compound represented by the formula (1).
[13] The adhesive composition according to [11] or [12], wherein, in the formula (1), R¹, R², R⁷, and R⁸ each represent a hydrogen atom, and R³ to R⁶ each independently represent a hydrogen atom or an alkyl group.
[14] The adhesive composition according to any one of [11] to [13], wherein, in the formula (1), the alkyl groups each independently have 1 to 12 carbon atoms.
[15] The adhesive composition according to [11], wherein the crosslinking inhibitor contains a compound represented by the formula (2).
[16] The adhesive composition according to [11] or [15], wherein, in the formula (2), R¹¹ to R¹³ each independently represent an alkyl group optionally having a substituent or a phenyl group optionally having a substituent.
[17] The adhesive composition according to [16], wherein, in the formula (2), the alkyl groups each independently have 1 to 12 carbon atoms.
[18] A method for producing a laminate, the method including:
   a step of applying the adhesive composition according to any one of [10] to [17] on a semiconductor substrate or on a support substrate to form an adhesive coating layer;
   a step of bonding the semiconductor substrate and the support substrate to each other through the adhesive coating layer; and
   a step of heating the semiconductor substrate, the adhesive coating layer, and the support substrate to form an adhesive layer from the adhesive coating layer.
[19] The method for producing a laminate according to [18], wherein the heating is performed from a side of the semiconductor substrate or a side of the support substrate.

### Advantageous Effects of Invention

According to the present invention, it is possible to provide a laminate capable of reducing warpage as compared with the case of using 1,1-diphenyl-2-propyne-1-ol as a crosslinking inhibitor, a method for producing a processed semiconductor substrate using the laminate, an adhesive composition used for forming an adhesive layer in the laminate, and a method for producing an adhesive layer using the adhesive composition.

### Brief Description of Drawings

FIG. 1 is a schematic cross-sectional view of an example of a laminate of the present invention.
FIG. 2 is a schematic cross-sectional view of another example of a laminate of the present invention.

### Description of Embodiments

### (Laminate)

The laminate of the present invention includes at least a semiconductor substrate, a support substrate, and an adhesive layer, and further includes other layers as necessary.

### <Semiconductor substrate>

The main material constituting the entire semiconductor substrate is not particularly limited as long as it is used for this type of application, and examples thereof include silicon, silicon carbide, and a compound semiconductor.

The shape of the semiconductor substrate is not particularly limited, and is, for example, a disk shape. Note that the disk-shaped semiconductor substrate does not need to have a completely circular surface. For example, the outer periphery of the semiconductor substrate may have a straight portion called an orientation flat or may have a cut called a notch.

The thickness of the disk-shaped semiconductor substrate may be appropriately determined according to the purpose of use of the semiconductor substrate and the like, and is not particularly limited, and is, for example, 500 to 1,000 um.

The diameter of the disk-shaped semiconductor substrate may be appropriately determined according to the purpose of use of the semiconductor substrate and the like, and is not particularly limited, and is, for example, 100 to 1,000 mm.

The semiconductor substrate may have a bump. The bump is a protruding terminal.

In the laminate, when the semiconductor substrate has a bump, the semiconductor substrate has the bump on the support substrate side.

In the semiconductor substrate, the bump is usually formed on a surface on which a circuit is formed. The circuit may be a single layer or a multilayer. The shape of the circuit is not particularly limited.

In the semiconductor substrate, the surface opposite to the surface having a bump (back surface) is a surface to be processed.

The material, size, shape, structure, and density of the bump the semiconductor substrate has are not particularly limited.

Examples of the bump include a ball bump, a printed bump, a stud bump, and a plated bump.

Usually, the height, radius, and pitch of the bump are appropriately determined from the conditions of a bump height of about 1 to 200 um, a bump radius of 1 to 200 um, and a bump pitch of 1 to 500 um.

Examples of the material of the bump include low-melting-point solder, high-melting-point solder, tin, indium, gold, silver, and copper. The bump may be composed only of a single component or may be composed of a plurality of components. More specific examples thereof include an alloy plating mainly containing Sn, such as SnAg bumps, SnBi bumps, Sn bumps, and AuSn bumps.

In addition, the bump may have a layered structure having a metal layer composed of at least one of these components.

An example of the semiconductor substrate is a silicon wafer having a diameter of about 300 mm and a thickness of about 770 µm.

### <Support substrate>

The support substrate is not particularly limited as long as it is a member capable of supporting the semiconductor substrate when the semiconductor substrate is processed. Examples thereof include a glass support substrate and a silicon support substrate.

The shape of the support substrate is not particularly limited, and examples thereof include a disk shape. Note that the disk-shaped support substrate does not need to have a complete circular surface. For example, the outer periphery of the support substrate may have a straight portion called an orientation flat or may have a cut called a notch.

The thickness of the disk-shaped support substrate may be appropriately determined according to the size of the semiconductor substrate and the like, and is not particularly limited, and is, for example, 500 to 1,000 um.

The diameter of the disk-shaped support substrate may be appropriately determined according to the size of the semiconductor substrate and the like, and is not particularly limited, and is, for example, 100 to 1,000 mm.

An example of the support substrate is a glass wafer or a silicon wafer having a diameter of 300 mm and a thickness of about 700 µm.

When the laminate is subjected to peeling by light irradiation, for example, a substrate optically transparent to light to be used is used as the support substrate.

### <Adhesive layer>

The adhesive layer is formed from the cured product of the adhesive composition.

### <<Adhesive composition>>

The adhesive composition contains at least a polyorganosiloxane (a1), a polyorganosiloxane (a2), a platinum group metal-based catalyst (A2), and a crosslinking inhibitor (A3), and further contains other components as necessary.

The adhesive composition is also an object of the present invention.

### <<<Polyorganosiloxane (a1) and polyorganosiloxane (a2)>>>

The polyorganosiloxane (a1) is a polyorganosiloxane that has an alkenyl group having 2 to 40 carbon atoms and bonded to a silicon atom.

The polyorganosiloxane (a2) is a polyorganosiloxane having a Si-H group.

Here, the alkenyl group having 2 to 40 carbon atoms may be substituted. Examples of the substituent include a halogen atom, a nitro group, a cyano group, an amino group, a hydroxy group, a carboxyl group, an aryl group, and a heteroaryl group.

An example of the polyorganosiloxane (a1) having an alkenyl group having 2 to 40 carbon atoms and bonded to a silicon atom is a polyorganosiloxane (a1') that contains one or two or more of units selected from the group consisting of a siloxane unit represented by SiO₂ (Q' unit), a siloxane unit represented by R¹' R²' R³' SiO_{1/2} (M' unit), a siloxane unit represented by R⁴'R⁵'SiO_{2/2} (D' unit), and a siloxane unit represented by R⁶'SiO_{3/2} (T' unit), and contains at least one kind selected from the group consisting of the M' unit, the D' unit, and the T' unit.

An example of the Si-H group-containing polyorganosiloxane (a2) is a polyorganosiloxane (a2') that contains one or two or more units selected from the group consisting of a siloxane unit represented by SiO₂ (Q" unit), a siloxane unit represented by R¹"R²"R³"SiO_{1/2} (M" unit), a siloxane unit represented by R⁴"R⁵"SiO_{2/2} (D" unit), and a siloxane unit represented by R⁶"SiO_{3/2} (T" unit), and contains at least one selected from the group consisting of the M" unit, the D" unit, and the T" unit.

R¹' to R⁶' are groups bonded to a silicon atom and each independently represent an optionally substituted alkyl group or an optionally substituted alkenyl group, and at least one of R¹' to R⁶' is an optionally substituted alkenyl group. Examples of the substituent include a halogen atom, a nitro group, a cyano group, an amino group, a hydroxy group, a carboxyl group, an aryl group, and a heteroaryl group.

R¹" to R⁶" are groups or atoms bonded to a silicon atom and each independently represent an optionally substituted alkyl group or a hydrogen atom, and at least one of R¹" to R⁶" is a hydrogen atom. Examples of the substituent include a halogen atom, a nitro group, a cyano group, an amino group, a hydroxy group, a carboxyl group, an aryl group, and a heteroaryl group.

The alkyl group may be linear, branched, or cyclic, and is preferably a linear or branched alkyl group. The number of carbon atoms thereof is not particularly limited, and is usually 1 to 40, preferably 30 or less, more preferably 20 or less, and still more preferably 10 or less.

Specific examples of the linear or branched and optionally substituted alkyl group include a methyl group, an ethyl group, a n-propyl group, an i-propyl group, a n-butyl group, an i-butyl group, a s-butyl group, a tertiary butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, but are not limited thereto. The number of carbon atoms thereof is usually 1 to 14, preferably 1 to 10, and more preferably 1 to 6. Among them, a methyl group is particularly preferable.

Specific examples of the cyclic and optionally substituted alkyl group include: cycloalkyl groups, such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and bicycloalkyl groups, such as a bicyclobutyl group, a bicyclopentyl group, a bicyclohexyl group, a bicycloheptyl group, a bicyclooctyl group, a bicyclononyl group, and a bicyclodecyl group, but are not limited thereto. The number of carbon atoms thereof is usually 3 to 14, preferably 4 to 10, and more preferably 5 to 6.

The alkenyl group may be linear or branched, and the number of carbon atoms thereof is not particularly limited, and is usually 2 to 40, and is preferably 30 or less, more preferably 20 or less, and still more preferably 10 or less.

Specific examples of the linear or branched and optionally substituted alkenyl group include a vinyl group, an allyl group, a butenyl group, and a pentenyl group, and are not limited thereto. The number of carbon atoms thereof is usually 2 to 14, preferably 2 to 10, and more preferably 1 to 6. Among them, an ethenyl group and a 2-propenyl group are particularly preferable.

Specific examples of the cyclic and optionally substituted alkenyl group include, but are not limited to, cyclopentenyl and cyclohexenyl. The number of carbon atoms thereof is usually 4 to 14, preferably 5 to 10, and more preferably 5 to 6.

The polyorganosiloxane (a1') contains one or two or more units selected from the group consisting of the Q' unit, the M' unit, the D' unit, and the T' unit, and also contains at least one selected from the group consisting of the M' unit, the D' unit, and the T' unit. As the polyorganosiloxane (a1'), two or more kinds of polyorganosiloxane satisfying such conditions may be used in combination.

Preferred combinations of two or more selected from the group consisting of the Q' unit, the M' unit, the D' unit, and the T' unit include, but are not limited to, (the Q' unit and the M' unit), (the D' unit and the M' unit), (the T' unit and the M' unit), and (the Q' unit, the T' unit, and the M' unit).

When the polyorganosiloxane (a1') contains two or more kinds of polyorganosiloxane, a combination of (the Q' unit and the M' unit) and (the D' unit and the M' unit), a combination of (the T' unit and the M' unit) and (the D' unit and the M' unit), and a combination of (the Q' unit, the T' unit, and the M' unit) and (the T' unit and the M' unit) are preferable, but the combination is not limited thereto.

The polyorganosiloxane (a2') contains one or two or more units selected from the group consisting of the Q" unit, the M" unit, the D" unit, and the T" unit, and also contains at least one selected from the group consisting of the M" unit, the D" unit, and the T" unit. As the polyorganosiloxane (a2'), two or more kinds of polyorganosiloxane satisfying such conditions may be used in combination.

Preferred combinations of two or more selected from the group consisting of the Q" unit, the M" unit, the D" unit, and the T" unit include, but are not limited to, (the M" unit and the D" unit), (the Q" unit and the M" unit), and (the Q" unit, the T" unit, and the M" unit).

The polyorganosiloxane (a1') is composed of siloxane units in which alkyl groups and/or alkenyl groups are bonded to silicon atoms thereof, and the ratio of alkenyl groups in the total substituents represented by R¹' to R⁶' is preferably 0.1 to 50.0 mol% and more preferably 0.5 to 30.0 mol%, and the remaining R¹' to R⁶' may be alkyl groups.

The polyorganosiloxane (a2') is composed of siloxane units in which alkyl groups and/or hydrogen atoms are bonded to silicon atoms thereof, and the ratio of hydrogen atoms in the total substituent groups and substituent atoms represented by R¹" to R⁶" is preferably 0.1 to 50.0 mol% and more preferably 10.0 to 40.0 mol%, and the remaining R¹" to R⁶" may be alkyl groups.

The weight average molecular weight of the polysiloxanes such as the polyorganosiloxane (a1) and the polyorganosiloxane (a2) is not particularly limited, and is usually 500 to 1,000,000, and is preferably 5,000 to 50,000 from the viewpoint of reproducibly realizing the effects of the present invention.

The weight average molecular weight, the number average molecular weight, and the dispersity of the polyorganosiloxanes can be measured, for example, using a GPC apparatus (EcoSEC, HLC-8320GPC; manufactured by Tosoh Corporation) and a GPC column (TSKgel SuperMultipore HZ-N and TSKgel SuperMultipore HZ-H; manufactured by Tosoh Corporation), at a column temperature of 40°C, using tetrahydrofuran as an eluent (elution solvent), at a flow amount (flow rate) of 0.35 mL/min, and using polystyrene (Shodex from Showa Denko K.K.) as a standard sample.

The viscosity of each of the polyorganosiloxane (a1) and the polyorganosiloxane (a2) is not particularly limited, but is usually 10 to 1000000 (mPa·s), and is preferably 50 to 10000 (mPa·s) from the viewpoint of reproducibly realizing the effects of the present invention. The viscosity of each of the polyorganosiloxane (a1) and the polyorganosiloxane (a2) is a value measured with an E-type rotational viscometer at 25°C.

The polyorganosiloxane (a1) and the polyorganosiloxane (a2) react with each other through hydrosilylation reaction to form a film. Therefore, the curing mechanism is different from that via, for example, silanol groups. Therefore, either siloxane does not need to contain a silanol group or a functional group that forms a silanol group through hydrolysis, such as an alkyloxy group.

In the adhesive composition, the molar ratio between the alkenyl groups contained in the polyorganosiloxane (a1) and the hydrogen atoms constituting a Si-H bond contained in the polyorganosiloxane (a2) (alkenyl group : hydrogen atom constituting Si-H bond) is preferably in the range of 1.0 : 0.5 to 1.0 : 0.66.

### <<<Platinum group metal-based catalyst (A2)>>>

The platinum group metal-based catalyst (A2) is a platinum-based metal catalyst.

Such a platinum-based metal catalyst is a catalyst to promote hydrosilylation reaction between the alkenyl group of the polyorganosiloxane (a1) and the Si-H group of the polyorganosiloxane (a2).

As a specific example of the platinum-based metal catalyst, a known platinum-based compound (platinum or a compound containing platinum) can be used.

Specific examples thereof include a platinum fine powder, platinum black, chloroplatinic acid, an alcohol modified product of chloroplatinic acid, a complex of chloroplatinic acid and diolefin, a platinum-olefin complex, a platinum-carbonyl complex [platinum bis(acetoacetate), platinum bis(acetylacetonate), and the like], a chloroplatinic acid-alkenylsiloxane complex (chloroplatinic acid-divinyltetramethyldisiloxane complex, chloroplatinic acid-tetravinyltetramethylcyclotetrasiloxane complex, etc.), a platinum-alkenylsiloxane complex (platinum-divinyltetramethyldisiloxane complex, platinum-tetravinyltetramethylcyclotetrasiloxane complex, etc.), and a complex of chloroplatinic acid and acetylene alcohols. Among them, a platinum-alkenylsiloxane complex is particularly preferable because it is highly effective in accelerating a hydrosilylation reaction.

These hydrosilylation catalysts may be used singly or in combination of two or more kinds thereof.

The alkenyl siloxane used in the platinum-alkenyl siloxane complex is not particularly limited, and examples thereof include 1,3-divinyl-1,1,3,3-tetramethyldisiloxane, 1,3,5,7-tetramethyl-1,3,5,7-tetravinylcyclotetrasiloxane, alkenyl siloxane oligomers in which some of the methyl groups of these alkenyl siloxanes are substituted with ethyl groups, phenyl groups, and the like, and alkenyl siloxane oligomers in which the vinyl groups of these alkenyl siloxanes are substituted with allyl groups, hexenyl groups, and the like. In particular, 1,3-divinyl-1,1,3,3-tetramethyldisiloxane is preferable because the produced platinum-alkenylsiloxane complex has good stability.

The content of the platinum group metal-based catalyst (A2) in the adhesive composition is not particularly limited, but is usually in the range of 1.0 to 50.0 ppm with respect to the total mass amount of the polyorganosiloxane (a1) and the polyorganosiloxane (a2).

### <<<Crosslinking inhibitor (A3)>>>

The crosslinking inhibitor (A3) contained in the adhesive composition contains at least one of a pyridine ring-containing compound and a phosphorus-containing organic compound.

The crosslinking inhibitor (A3), containing at least one of a pyridine ring-containing compound and a phosphorus-containing organic compound, is capable of reducing warpage of the laminate as compared with the case of using 1,1-diphenyl-2-propyne-1-ol as a crosslinking inhibitor. The present inventors presume that this is because the curing rate of the adhesive composition utilizing hydrosilylation reaction is controlled to alleviate the stress of the laminate.

The present inventors presume that this is related to the fact that the pyridine ring-containing compound and the phosphorus-containing organic compound have higher coordination ability to the platinum group metal-based catalyst than that of 1,1-diphenyl-2-propyne-1-ol.

The pyridine ring-containing compound is not particularly limited, but preferably contains a compound represented by the following formula (1) from the viewpoint of being more excellent in the effect of reducing warpage.

The phosphorus-containing organic compound is not particularly limited, but preferably contains a compound represented by the following formula (2) from the viewpoint of being more excellent in the effect of reducing warpage.

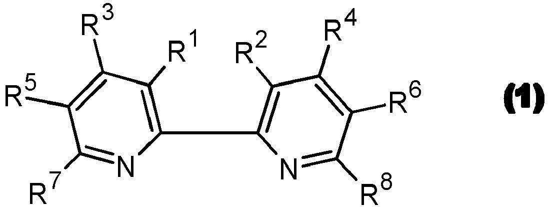

In the formula (1), R¹ and R² each independently represent a hydrogen atom or an alkyl group optionally having a substituent, or R¹ and R² are combined with each other to form an aromatic hydrocarbon ring that may have an alkyl group optionally having a substituent, or to form - O-;
R³ and R⁴ each independently represent a hydrogen atom or an alkyl group optionally having a substituent;
R⁵ and R⁶ each independently represent a hydrogen atom or an alkyl group optionally having a substituent;
R⁷ and R⁸ each independently represent a hydrogen atom or an alkyl group optionally having a substituent;
R⁵ and R⁷, instead of the above definition, may be combined with each other to form an aromatic hydrocarbon ring that may have an alkyl group optionally having a substituent; and
R⁶ and R⁸, instead of the above definition, may be combined with each other to form an aromatic hydrocarbon ring that may have an alkyl group optionally having a substituent.

The number of carbon atoms of the alkyl group in the formula (1) is not particularly limited, and is each independently 1 to 12, for example.

The alkyl group in the formula (1) may be linear or branched.

Examples of the alkyl group in the formula (1) include a methyl group, an ethyl group, a propyl group, an isopropyl group, a butyl group, an isobutyl group, a tert-butyl group, a pentyl group, a hexyl group, an octyl group, and a nonyl group.

Examples of the substituent in the alkyl group optionally having a substituent in the formula (1) include a halogen atom, an alkoxy group, an acyl group, a hydroxy group, a carboxy group, an amino group, an imino group, a cyano group, a phenyl group, a thiol group, a sulfo group, a nitro group, an aryl group, and a heteroaryl group. Examples of the alkoxy group include an alkoxy group having 1 to 6 carbon atoms. Examples of the acyl group include an acyl group having 2 to 7 carbon atoms.

Examples of the aromatic hydrocarbon ring that R¹ and R² are combined with each other to form include a benzene ring.

Examples of the aromatic hydrocarbon ring that R⁵ and R⁷ are combined with each other to form include a benzene ring.

Examples of the aromatic hydrocarbon ring that R⁶ and R⁸ are combined with each other to form include a benzene ring.

In the formula (1), R¹, R², R⁷, and R⁸ preferably represent a hydrogen atom, and R³ to R⁶ preferably each independently represent a hydrogen atom or an alkyl group.

For example, R² and R⁴ are both a hydrogen atom or the same group.

For example, R⁵ and R⁶ are both a hydrogen atom or the same group.

For example, when R⁵ and R⁷ are combined with each other to form an aromatic hydrocarbon ring that may have an alkyl group optionally having a substituent, R⁶ and R⁸ are combined with each other to form the same aromatic hydrocarbon ring.

Examples of the compound represented by the formula (1) include a compound represented by the following formula (1-1), a compound represented by the following formula (1-2), a compound represented by the following formula (1-3), and a compound represented by the following formula (1-4). Among them, a compound represented by the following formula (1-1) and a compound represented by the following formula (1-2) are preferable from the viewpoint of further reducing warpage.

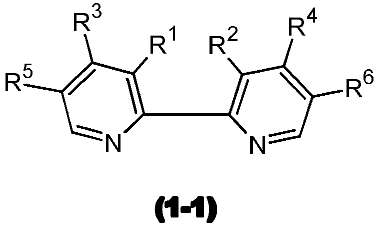

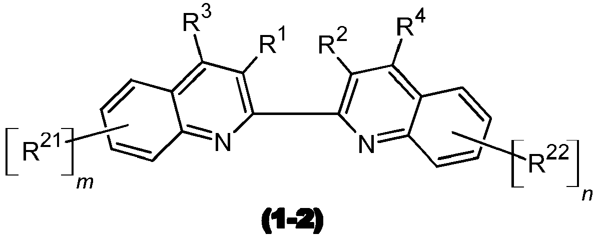

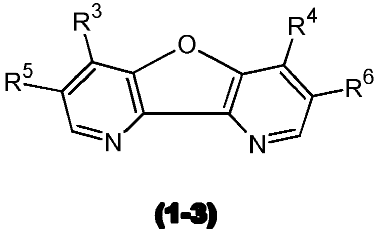

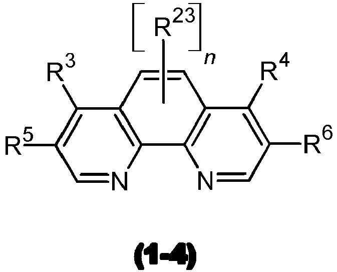

In the formula (1-1), R¹ to R⁶ each independently represent a hydrogen atom or an alkyl group optionally having a substituent.

In the formula (1-2), R¹ to R⁴ each independently represent a hydrogen atom or an alkyl group optionally having a substituent. R²¹ and R²² each independently represent an alkyl group optionally having a substituent. "m" and "n" each independently represent an integer of 0 to 4. When "m" is 2 or more, the plurality of R²¹s may be the same or different. When "n" is 2 or more, the plurality of R²²s may be the same or different.

In the formula (1-3), R³ to R⁶ each independently represent a hydrogen atom or an alkyl group optionally having a substituent.

In the formula (1-4), R³ to R⁶ each independently represent a hydrogen atom or an alkyl group optionally having a substituent. R²³ represents an alkyl group optionally having a substituent. "n" represents an integer of 0 to 2. When "n" is 2, the plurality of R²³s may be the same or different.

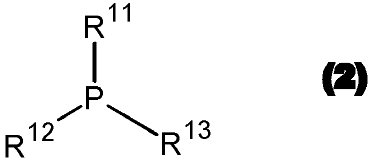

In the formula (2), R¹¹ to R¹³ each independently represent a hydrocarbon group optionally having a substituent.

P represents a phosphorus atom.

For example, R¹¹ to R¹³ each independently represent an alkyl group optionally having a substituent or a phenyl group optionally having a substituent.

The number of carbon atoms of the alkyl group in the alkyl group optionally having a substituent in R¹¹ to R¹³ is not particularly limited, and is independently 1 to 12, for example.

The alkyl group may be linear or branched.

Examples of the alkyl group include a methyl group, an ethyl group, a propyl group, an isopropyl group, a butyl group, an isobutyl group, a tert-butyl group, a pentyl group, a hexyl group, an octyl group, and a nonyl group.

Examples of the substituent in the hydrocarbon group optionally having a substituent in R¹¹ to R¹³ include a halogen atom, an alkoxy group, an acyl group, a hydroxy group, a carboxy group, an amino group, an imino group, a cyano group, a phenyl group, a thiol group, a sulfo group, a nitro group, an aryl group, and a heteroaryl group. Examples of the alkoxy group include an alkoxy group having 1 to 6 carbon atoms. Examples of the acyl group include an acyl group having 2 to 7 carbon atoms.

For example, R¹¹ to R¹³ are the same group.

The content of at least one of a pyridine ring-containing compound and a phosphorus-containing organic compound in the adhesive composition is not particularly limited, but is preferably 0.01 to 10 mass% and more preferably 0.1 to 0.5 mass% with respect to the nonvolatile component from the viewpoint of reproducibly realizing the effect of the present invention.

### <<<Other components>>>

The other components are not particularly limited, and examples thereof include a solvent and a release agent component.

### <<<<Solvent>>>>

The adhesive composition may contain a solvent for the purpose of adjusting the viscosity. Specific examples thereof include aliphatic hydrocarbons, aromatic hydrocarbons, and ketones, but are not limited thereto.

More specific examples of the solvent include hexane, heptane, octane, nonane, decane, undecane, dodecane, isododecane, menthane, limonene, toluene, xylene, mesitylene, cumene, MIBK (methyl isobutyl ketone), butyl acetate, diisobutyl ketone, 2-octanone, 2-nonanone, and 5-nonanone, but are not limited thereto. Such solvents can be used singly or in combination of two or more kinds thereof.

When the adhesive composition contains a solvent, the content thereof is appropriately determined in consideration of the desired viscosity of the composition, the coating method to be employed, the thickness of the film to be produced, and the like, and is in a range of about 10 to 90 mass% with respect to the entire composition.

### <<<<Release agent component>>>>

The adhesive composition may contain a release agent component. For example, when the laminate does not have the release layer, the adhesive composition contains a release agent component.

By containing the release agent component in the adhesive composition, the resulting adhesive layer can be suitably released with good reproducibility.

Typical examples of the release agent component include non-curable polyorganosiloxanes, and specific examples thereof include epoxy group-containing polyorganosiloxanes, methyl group-containing polyorganosiloxanes, and phenyl group-containing polyorganosiloxanes, but are not limited thereto.

Here, in the description, the term "non-curable" means that hydrosilylation reaction does not occur.

Examples of the release agent component include polydimethylsiloxane. The polydimethylsiloxane may be modified. Examples of the optionally modified polydimethylsiloxane include, but are not limited to, an epoxy group-containing polydimethylsiloxane, an unmodified polydimethylsiloxane, and a phenyl group-containing polydimethylsiloxane.

Preferred examples of the polyorganosiloxane as the release agent component include epoxy group-containing polyorganosiloxanes, methyl group-containing polyorganosiloxanes, and phenyl group-containing polyorganosiloxanes, but are not limited thereto.

The weight average molecular weight of the polyorganosiloxane as the release agent component is not particularly limited, but is usually 100,000 to 2,000,000, and is preferably 200,000 to 1,200,000, and more preferably 300,000 to 900,000. In addition, the dispersity is not particularly limited, but is usually 1.0 to 10.0, and is preferably 1.5 to 5.0, and more preferably 2.0 to 3.0 from the viewpoint of reproducibly realizing suitable peeling. The weight average molecular weight and the dispersity can be measured by the above-described method relating to the polyorganosiloxane.

The viscosity of the polyorganosiloxane as the release agent component is not particularly limited, but is usually 1,000 to 2,000,000 mm²/s. The value of the viscosity of the polyorganosiloxane as the release agent component is expressed by kinematic viscosity, and centistokes (cSt) = mm²/s. The value can also be determined by dividing the viscosity (mPa·s) by the density (g/cm³). That is, the value can be determined from the viscosity measured with an E-type rotational viscometer measured at 25°C and the density, and can be calculated from the equation: kinematic viscosity (mm²/s) = viscosity (mPa·s)/density (g/cm³).

Examples of the epoxy group-containing polyorganosiloxane include those containing a siloxane unit (D¹⁰ unit) represented by R²¹¹R¹¹²SiO_{2/2}.

R¹¹¹ is a group bonded to a silicon atom and represents an alkyl group. R¹¹² is a group bonded to a silicon atom and represents an epoxy group or an organic group containing an epoxy group. Specific examples of the alkyl group include the above-described examples regarding R¹' to R⁶'.

The epoxy group in the organic group containing an epoxy group may be an independent epoxy group that is not fused with other rings, or may be an epoxy group forming a fused ring with other rings, such as a 1,2-epoxycyclohexyl group.

Specific examples of the organic group containing an epoxy group include, but are not limited to, 3-glycidoxypropyl and 2-(3,4-epoxycyclohexyl) ethyl.

Preferred examples of the epoxy group-containing polyorganosiloxane include, but are not limited to, an epoxy group-containing polydimethylsiloxane.

The epoxy group-containing polyorganosiloxane contains the above-described siloxane unit (D¹⁰ unit), and may contain the Q unit, the M unit, and/or the T unit in addition to the D¹⁰ unit.

Specific examples of the epoxy group-containing polyorganosiloxane include a polyorganosiloxane composed only of the D¹⁰ unit, a polyorganosiloxane containing the D¹⁰ unit and the Q unit, a polyorganosiloxane containing the D¹⁰ unit and the M unit, a polyorganosiloxane containing the D¹⁰ unit and the T unit, a polyorganosiloxane containing the D¹⁰ unit, the Q unit, and the M unit, a polyorganosiloxane containing the D¹⁰ unit, the M unit, and the T unit, and a polyorganosiloxane containing the D¹⁰ unit, the Q unit, the M unit, and the T unit.

The epoxy group-containing polyorganosiloxane is preferably an epoxy group-containing polydimethylsiloxane having an epoxy value of 0.1 to 5. The weight average molecular weight thereof is not particularly limited, and is usually 1,500 to 500,000, and is preferably 100,000 or less from the viewpoint of suppressing precipitation in the composition.

Specific examples of the epoxy group-containing polyorganosiloxane include, but are not limited to, those represented by the formulae (E1) to (E3). 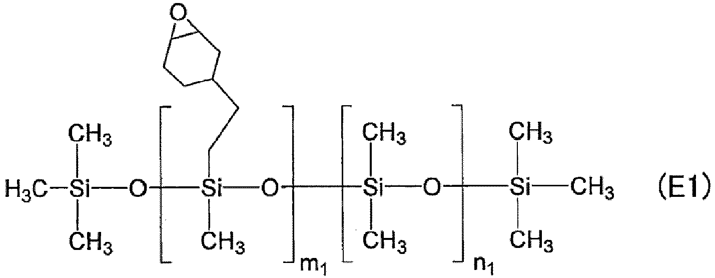 (m₁ and n₁ represent the number of each repeating unit, and are positive integers.) 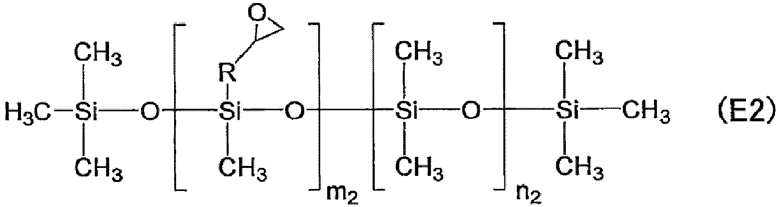 (m₂ and n₂ represent the number of each repeating unit and are positive integers, and R is an alkylene group having 1 to 10 carbon atoms.) 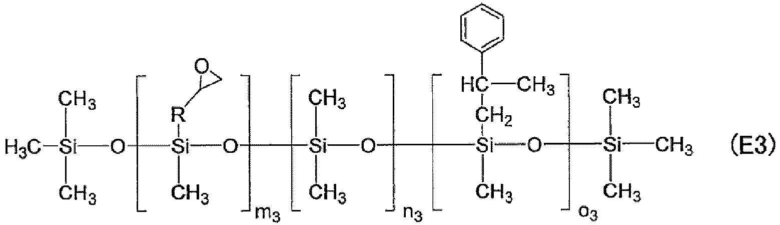 (m₃, n₃, and o₃ represent the number of each repeating unit, and are positive integers, and R is an alkylene group having 1 to 10 carbon atoms.)

Examples of the methyl group-containing polyorganosiloxane include those containing a siloxane unit (D²⁰⁰ unit) represented by R²¹⁰R²²⁰SiO_{2/2}, and preferably those containing a siloxane unit (D²⁰ unit) represented by R²²¹R²²¹SiQ_{2/2}.

R²¹⁰ and R²²⁰ are groups bonded to a silicon atom, and each independently represent an alkyl group, and at least one thereof is a methyl group, and specific examples of the alkyl group include the above-described examples.

R²²¹ is a group bonded to a silicon atom and represents an alkyl group, and specific examples of the alkyl group include the above examples. Among them, R²²¹ is preferably a methyl group.

Preferred examples of the methyl group-containing polyorganosiloxane include, but are not limited to, polydimethylsiloxane.

The methyl group-containing polyorganosiloxane contains the above-described siloxane units (the D²⁰⁰ unit or the D²⁰ unit), and may contain the Q unit, the M unit, and/or the T unit in addition to the D²⁰⁰ unit and the D²⁰ unit.

In an embodiment, specific examples of the methyl group-containing polyorganosiloxane include a polyorganosiloxane composed only of the D²⁰⁰ unit, a polyorganosiloxane containing the D²⁰⁰ unit and the Q unit, a polyorganosiloxane containing the D²⁰⁰ unit and the M unit, a polyorganosiloxane containing the D²⁰⁰ unit and the T unit, a polyorganosiloxane containing the D²⁰⁰ unit, the Q unit, and the M unit, a polyorganosiloxane containing the D²⁰⁰ unit, the M unit, and the T unit, and a polyorganosiloxane containing the D²⁰⁰ unit, the Q unit, the M unit, and the T unit.

Specific examples of the methyl group-containing polyorganosiloxane include a polyorganosiloxane composed only of the D²⁰ unit, a polyorganosiloxane containing the D²⁰ unit and the Q unit, a polyorganosiloxane containing the D²⁰ unit and the M unit, a polyorganosiloxane containing the D²⁰ unit and the T unit, a polyorganosiloxane containing the D²⁰ unit, the Q unit, and the M unit, a polyorganosiloxane containing the D²⁰ unit, the M unit, and the T unit, and a polyorganosiloxane containing the D²⁰ unit, the Q unit, the M unit, and the T unit.

Specific examples of the methyl group-containing polyorganosiloxane include, but are not limited to, those represented by the formula (M1). 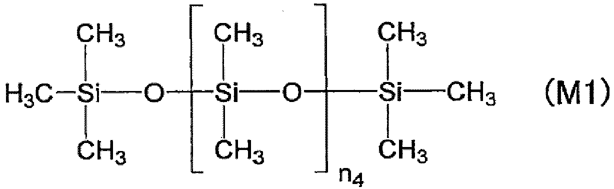 (n₄ represents the number of repeating units, and is a positive integer.)

Examples of the phenyl group-containing polyorganosiloxane include those containing a siloxane unit (D³⁰ unit) represented by R³¹R³²SiO_{2/2}.

R³¹ is a group bonded to a silicon atom and represents a phenyl group or an alkyl group. R³² is a group bonded to a silicon atom and represents a phenyl group. Specific examples of the alkyl group include the above-described examples, and a methyl group is preferable.

The phenyl group-containing polyorganosiloxane contains the above-described siloxane unit (D³⁰ unit), and may contain the Q unit, the M unit, and/or the T unit in addition to the D³⁰ unit.

Specific examples of the phenyl group-containing polyorganosiloxane include a polyorganosiloxane composed only of the D³⁰ unit, a polyorganosiloxane containing the D³⁰ unit and the Q unit, a polyorganosiloxane containing the D³⁰ unit and the M unit, a polyorganosiloxane containing the D³⁰ unit and the T unit, a polyorganosiloxane containing the D³⁰ unit, the Q unit, and the M unit, a polyorganosiloxane containing the D³⁰ unit, the M unit, and the T unit, and a polyorganosiloxane containing the D³⁰ unit, the Q unit, the M unit, and the T unit.

Specific examples of the phenyl group-containing polyorganosiloxane include, but are not limited to, those represented by the formula (P1) or (P2). 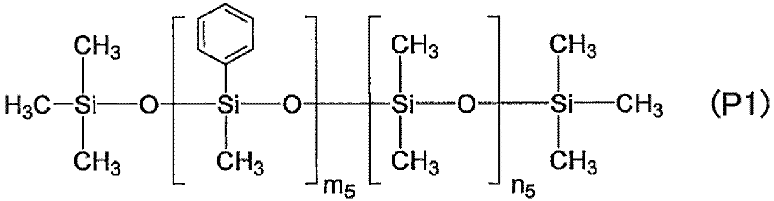 (m₅ and n₅ represent the number of each repeating unit, and are positive integers.) 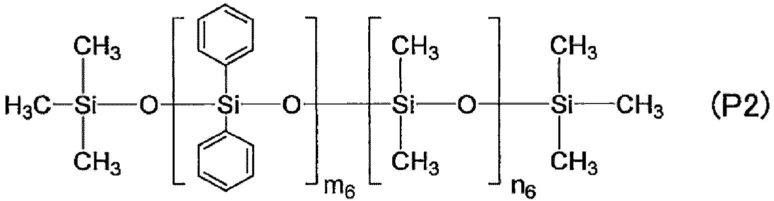 (m₆ and n₆ represent the number of each repeating unit, and are positive integers.)

The polyorganosiloxane as the release agent component may be a commercially available product or a synthetic product.

Examples of commercially available products of the polyorganosiloxane include WACKERSILICONE FLUID AK series (AK 50, AK 350, AK 1000, AK 10000, AK 1000000) and GENIOPLAST GUM, which are products manufactured by Wacker Chemie AG, dimethyl silicone oils (KF-96L, KF-96A, KF-96, KF-96H, KF-69, KF-965, KF-968) and a cyclic dimethyl silicone oil (KF-995), which are manufactured by Shin-Etsu Chemical Co., Ltd.; epoxy group-containing polyorganosiloxanes (trade name: CMS-227, ECMS-327), which are manufactured by Gelest, Inc., epoxy group-containing polyorganosiloxanes manufactured by Shin-Etsu Chemical Co., Ltd. (KF-101, KF-1001, KF-1005, X-22-343), an epoxy group-containing polyorganosiloxane manufactured by Dow Corning Corp. (BY16-839); phenyl group-containing polyorganosiloxanes manufactured by Gelest, Inc. (PMM-1043, PMM-1025, PDM-0421, PDM-0821), a phenyl group-containing polyorganosiloxane manufactured by Shin-Etsu Chemical Co., Ltd. (KF50-3000CS), phenyl group-containing polyorganosiloxanes manufactured by MOMENTIVE (TSF431, TSF433), and the like, but are not limited thereto.

The content of the release agent component in the adhesive composition is not particularly limited.

The viscosity of the adhesive composition is not particularly limited, but is usually 500 to 20,000 mPa·s, and preferably 1,000 to 5,000 mPa-s at 25°C. The viscosity of the adhesive composition can be adjusted by changing the type of solvent to be used, the ratio thereof, the concentration of the film constituent components, and the like, in consideration of various factors such as the coating method to be used and the desired film thickness.

For the purpose of removing foreign substances, a solvent, a solution, or the like to be used may be filtered using a filter or the like during the production of the adhesive composition or after mixing all the components.

The thickness of the adhesive layer is not particularly limited, and is usually 5 to 500 um, and is preferably 10 um or more, more preferably 20 µm or more, still more preferably 30 µm or more from the viewpoint of maintaining the film strength, and is preferably 200 µm or less, more preferably 150 µm or less, still more preferably 120 um or less, and still more preferably 70 µm or less from the viewpoint of avoiding nonuniformity caused by being a thick film.

The method for forming the adhesive layer from the adhesive composition is not particularly limited, and examples thereof include the method described in the method for producing a laminate described later.

### <Release layer>

The laminate may have a release layer.

In the laminate having the release layer, for example, the release layer is irradiated with light to separate the semiconductor substrate and the support substrate.

The release layer is formed from, for example, a release agent composition.

### <<Release agent composition>>

The release agent composition contains, for example, at least an organic resin or a polynuclear phenol derivative, and further contains other components as necessary.

The organic resin is preferably one that can exhibit a suitable releasing ability. In the case of separating the semiconductor substrate and the support substrate by light-irradiating the release layer, the organic resin absorbs light and suitably undergoes a deterioration that is necessary to improve releasing ability, for example, decomposition.

The laminate having a release layer formed from the release agent composition can be released without applying an excessive load for release, for example, by irradiating the release layer with a laser.

The release layer included in the laminate, for example, being irradiated with a laser, has lower adhesive strength than before irradiation. That is, in the laminate, for example, while the semiconductor substrate is subjected to processing such as thinning, the semiconductor substrate is suitably supported on the support substrate that transmits a laser via the adhesive layer and the release layer, and after the processing is completed, the laser transmitted through the support substrate is absorbed by the release layer by irradiating the laser from the support substrate side, and at the interface between the release layer and the adhesive layer, at the interface between the release layer and the support substrate or inside the release layer, the release layer is deteriorated (for example, separation), and as a result, suitable peeling can be realized without applying an excessive load for peeling.

Examples of the organic resin include a novolac resin. Details thereof will be described later.

As a preferred embodiment, the release agent composition contains at least a novolac resin, and further contains other components such as a crosslinking agent, an acid generator, an acid, a surfactant, and a solvent, as necessary.

As another preferred embodiment, the release agent composition contains at least a polynuclear phenol derivative and a crosslinking agent, and further contains other components such as an acid generator, an acid, a surfactant, and a solvent, as necessary.

As another preferred embodiment, the release agent composition contains at least an organic resin and a branched polysilane, and further contains other components such as a crosslinking agent, an acid generator, an acid, a surfactant, and a solvent, as necessary.

<<<Novolac resin>>>

The novolac resin is, for example, a resin obtained by condensation reaction of at least one of a phenolic compound, a carbazole compound, and an aromatic amine compound with at least one of an aldehyde compound, a ketone compound, and a divinyl compound under an acid catalyst.

Examples of the phenolic compound include phenols, naphthols, anthrols, hydroxypyrenes, and the like. Examples of the phenols include phenol, cresol, xylenol, resorcinol, bisphenol A, p-tert-butylphenol, p-octylphenol, 9,9-bis(4-hydroxyphenyl) fluorene, and 1,1,2,2-tetrakis(4-hydroxyphenyl) ethane. Examples of the naphthols include 1-naphthol, 2-naphthol, 1,5-dihydroxynaphthalene, 2,7-dihydroxynaphthalene, and 9,9-bis(6-hydroxynaphthyl) fluorene. Examples of the anthrols include 9-anthrol. Examples of the hydroxypyrenes include 1-hydroxypyrene and 2-hydroxypyrene.

Examples of the carbazole compound include carbazole, 1,3,6,8-tetranitrocarbazole, 3,6-diaminocarbazole, 3,6-dibromo-9-ethylcarbazole, 3,6-dibromo-9-phenylcarbazole, 3,6-dibromocarbazole, 3,6-dichlorocarbazole, 3-amino-9-ethylcarbazole, 3-bromo-9-ethylcarbazole, 4,4'-bis(9H-carbazole-9-yl) biphenyl, 4-glycidylcarbazole, 4-hydroxycarbazole, 9-(1H-benzotriazole-1-yl methyl)-9H-carbazole, 9-acetyl-3,6-diiodocarbazole, 9-benzoylcarbazole, 9-benzoylcarbazole-6-dicarboxyaldehyde, 9-benzylcarbazole-3-carboxyaldehyde, 9-methylcarbazole, 9-phenylcarbazole, 9-vinylcarbazole, carbazole potassium, carbazole-N-carbonyl chloride, N-ethylcarbazole-3-carboxaldehyde, N-((9-ethylcarbazole-3-yl) methylene)-2-methyl-1-indolinylamine, and the like.

Examples of the aromatic amine compound include diphenylamine and N-phenyl-1-naphthylamine.

These can be used singly or in combination of two or more kinds thereof.

These may have a substituent. For example, these may have a substituent on the aromatic ring.

Examples of the aldehyde compound include saturated aliphatic aldehydes such as formaldehyde, paraformaldehyde, acetaldehyde, propylaldehyde, butyraldehyde, isobutyraldehyde, valeraldehyde, capronaldehyde, 2-methylbutyraldehyde, hexylaldehyde, undecanealdehyde, 7-methoxy-3,7-dimethyloctylaldehyde, cyclohexanealdehyde, 3-methyl-2-butyraldehyde, glyoxal, malonaldehyde, succinaldehyde, glutaraldehyde, and adipinealdehyde; unsaturated aliphatic aldehydes such as acrolein and methacrolein; heterocyclic aldehydes such as furfural and pyridinealdehyde; and aromatic aldehydes such as benzaldehyde, naphthylaldehyde, anthrylaldehyde, phenanthrylaldehyde, salicylaldehyde, phenylacetaldehyde, 3-phenylpropionaldehyde, tolylaldehyde, (N,N-dimethylamino) benzaldehyde, and acetoxybenzaldehyde. Among them, aromatic aldehydes are preferable.

Examples of the ketone compound include diaryl ketone compounds such as diphenyl ketone, phenyl naphthyl ketone, dinaphthyl ketone, phenyl tolyl ketone, and ditolyl ketone.

Examples of the divinyl compound include divinylbenzene, dicyclopentadiene, tetrahydroindene, 4-vinylcyclohexene, 5-vinylnoborna-2-ene, divinylpyrene, limonene, and 5-vinylnorbornadiene.

These can be used singly or in combination of two or more kinds thereof.

The novolac resin is, for example, a novolac resin that absorbs light irradiated from the support substrate side and is altered. The alteration is, for example, photolysis.

The novolac resin includes, for example, at least one of a structural unit represented by the following formula (C1-1), a structural unit represented by the following formula (1-2), and a structural unit represented by the following formula (C1-3).

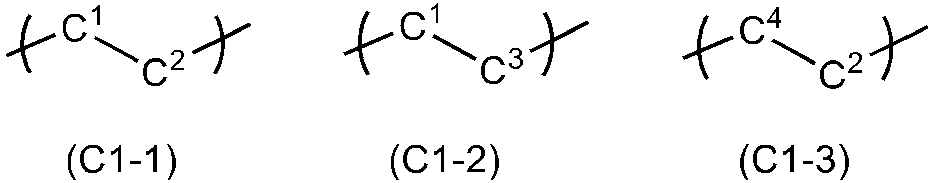

In the formula, C¹ represents a group derived from an aromatic compound containing a nitrogen atom. C² represents a group containing a tertiary carbon atom having at least one selected from the group consisting of a secondary carbon atom, a quaternary carbon atom, and an aromatic ring in its side chain. C³ represents a group derived from an aliphatic polycyclic compound. C⁴ represents a group derived from phenol, a group derived from bisphenol, a group derived from naphthol, a group derived from biphenyl, or a group derived from biphenol.

That is, the novolac resin contains, for example, one kind or two or more kinds of the following structural units.
- Structural unit having a bond between a group derived from an aromatic compound containing a nitrogen atom and a group containing a tertiary carbon atom having at least one selected from the group consisting of a secondary carbon atom, a quaternary carbon atom, and an aromatic ring in its side chain (formula (C1-1))
- Structural unit having a bond between a group derived from an aromatic compound containing a nitrogen atom and a group derived from an aliphatic polycyclic compound (formula (C1-2))
- Structural unit having a bond between a group derived from phenol, a group derived from bisphenol, a group derived from naphthol, a group derived from biphenyl, or a group derived from biphenol, and a group containing a tertiary carbon atom having at least one selected from the group consisting of a quaternary carbon atom and an aromatic ring in its side chain (formula (C1-3))

In a preferred embodiment, the novolac resin contains any one or both of a structural unit having a bond between a group derived from an aromatic compound containing a nitrogen atom and a group containing a tertiary carbon atom having at least one selected from the group consisting of a secondary carbon atom, a quaternary carbon atom, and an aromatic ring in its side chain (formula (C1-1)) and a structural unit having a bond between a group derived from an aromatic compound containing a nitrogen atom and a group derived from an aliphatic polycyclic compound (formula (C1-2)).

The group derived from an aromatic compound containing a nitrogen atom of C¹ can be, for example, a group derived from carbazole, a group derived from N-phenyl-1-naphthylamine, a group derived from N-phenyl-2-naphthylamine, or the like, but is not limited thereto.

The group containing a tertiary carbon atom having at least one selected from the group consisting of a secondary carbon atom, a quaternary carbon atom, and an aromatic ring in its side chain of C² can be, for example, a group derived from 1-naphthaldehyde, a group derived from 1-pyrenecarboxaldehyde, a group derived from 4-(trifluoromethyl) benzaldehyde, a group derived from acetaldehyde, or the like, but is not limited thereto.

The group derived from an aliphatic polycyclic compound of C³ can be, but is not limited to, a group derived from dicyclopentadiene.

C⁴ is a group derived from phenol, a group derived from bisphenol, a group derived from naphthol, a group derived from biphenyl, or a group derived from biphenol.

In a preferred embodiment, the novolac resin contains, for example, a structural unit represented by the following formula (C1-1-1) as the structural unit represented by the formula (C1-1).

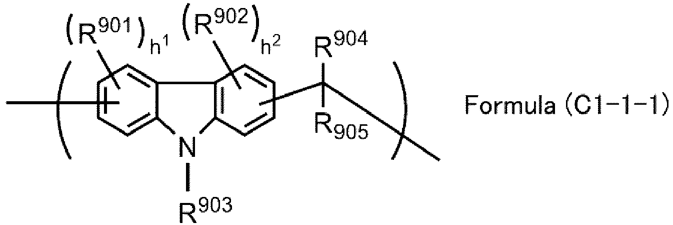

In the formula (C1-1-1), R⁹⁰¹ and R⁹⁰² represent a substituent substituted on the ring, and each independently represent a halogen atom, a nitro group, a cyano group, an amino group, a hydroxy group, a carboxy group, an optionally substituted alkyl group, an optionally substituted alkenyl group, or an optionally substituted aryl group.

R⁹⁰³ represents a hydrogen atom, an optionally substituted alkyl group, an optionally substituted alkenyl group, or an optionally substituted aryl group.

R⁹⁰⁴ represents a hydrogen atom, an optionally substituted aryl group, or an optionally substituted heteroaryl group.

R⁹⁰⁵ represents an optionally substituted alkyl group, an optionally substituted aryl group, or an optionally substituted heteroaryl group.

The group of R⁹⁰⁴ and the group of R⁹⁰⁵ may be bonded to each other to form a divalent group.

Examples of the substituent on the alkyl group and the alkenyl group include a halogen atom, a nitro group, a cyano group, an amino group, a hydroxy group, a carboxy group, an aryl group, and a heteroaryl group.

Examples of the substituent on the aryl group and the heteroaryl group include a halogen atom, a nitro group, a cyano group, an amino group, a hydroxy group, a carboxy group, an alkyl group, and an alkenyl group.

h¹ and h² each independently represent an integer of 0 to 3.

The number of carbon atoms of the optionally substituted alkyl group and the optionally substituted alkenyl group is usually 40 or less, and from the viewpoint of solubility, the number of carbon atoms is preferably 30 or less, and more preferably 20 or less.

The number of carbon atoms of the optionally substituted aryl group and heteroaryl group is usually 40 or less, and from the viewpoint of solubility, preferably 30 or less, and more preferably 20 or less.

Examples of the halogen atom include a fluorine atom, a chlorine atom, a bromine atom, and an iodine atom.

Specific examples of the optionally substituted alkyl group include a methyl group, an ethyl group, a n-propyl group, an i-propyl group, a n-butyl group, an i-butyl group, a s-butyl group, a t-butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, but are not limited thereto.

Specific examples of the optionally substituted alkenyl group include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, a 2-methyl-2-propenyl group, a 1-ethylethenyl group, a 1-methyl-1-propenyl group, a 1-methyl-2-propenyl group, a 1-pentenyl group, a 2-pentenyl group, a 3-pentenyl group, a 4-pentenyl group, a 1-n-propylethenyl group, a 1-methyl-1-butenyl group, a 1-methyl-2-butenyl group, a 1-methyl-3-butenyl group, a 2-ethyl-2-propenyl group, a 2-methyl-1-butenyl group, a 2-methyl-2-butenyl group, a 2-methyl-3-butenyl group, a 3-methyl-1-butenyl group, a 3-methyl-2-butenyl group, a 3-methyl-3-butenyl group, a 1,1-dimethyl-2-propenyl group, a 1-i-propylethenyl group, a 1,2-dimethyl-1-propenyl group, a 1,2-dimethyl-2-propenyl group, a 1-cyclopentenyl group, a 2-cyclopentenyl group, a 3-cyclopentenyl group, a 1-hexenyl group, a 2-hexenyl group, a 3-hexenyl group, a 4-hexenyl group, a 5-hexenyl group, a 1-methyl-1-pentenyl group, a 1-methyl-2-pentenyl group, a 1-methyl-3-pentenyl group, a 1-methyl-4-pentenyl group, a 1-n-butylethenyl group, a 2-methyl-1-pentenyl group, a 2-methyl-2-pentenyl group, a 2-methyl-3-pentenyl group, a 2-methyl-4-pentenyl group, a 2-n-propyl-2-propenyl group, a 3-methyl-1-pentenyl group, a 3-methyl-2-pentenyl group, a 3-methyl-3-pentenyl group, a 3-methyl-4-pentenyl group, a 3-ethyl-3-butenyl group, a 4-methyl-1-pentenyl group, a 4-methyl-2-pentenyl group, a 4-methyl-3-pentenyl group, a 4-methyl-4-pentenyl group, a 1,1-dimethyl-2-butenyl group, a 1,1-dimethyl-3-butenyl group, a 1,2-dimethyl-1-butenyl group, a 1,2-dimethyl-2-butenyl group, a 1,2-dimethyl-3-butenyl group, a 1-methyl-2-ethyl-2-propenyl group, a 1-s-butylethenyl group, a 1,3-dimethyl-1-butenyl group, a 1,3-dimethyl-2-butenyl group, a 1,3-dimethyl-3-butenyl group, a 1-i-butylethenyl group, a 2,2-dimethyl-3-butenyl group, a 2,3-dimethyl-1-butenyl group, a 2,3-dimethyl-2-butenyl group, a 2,3-dimethyl-3-butenyl group, a 2-i-propyl-2-propenyl group, a 3,3-dimethyl-1-butenyl group, a 1-ethyl-1-butenyl group, a 1-ethyl-2-butenyl group, a 1-ethyl-3-butenyl group, a 1-n-propyl-1-propenyl group, a 1-n-propyl-2-propenyl group, a 2-ethyl-1-butenyl group, a 2-ethyl-2-butenyl group, a 2-ethyl-3-butenyl group, a 1,1,2-trimethyl-2-propenyl group, a 1-t-butylethenyl group, a 1-methyl-1-ethyl-2-propenyl group, a 1-ethyl-2-methyl-1-propenyl group, a 1-ethyl-2-methyl-2-propenyl group, a 1-i-propyl-1-propenyl group, a 1-i-propyl-2-propenyl group, a 1-methyl-2-cyclopentenyl group, a 1-methyl-3-cyclopentenyl group, a 2-methyl-1-cyclopentenyl group, a 2-methyl-2-cyclopentenyl group, a 2-methyl-3-cyclopentenyl group, a 2-methyl-4-cyclopentenyl group, a 2-methyl-5-cyclopentenyl group, a 2-methylene-cyclopentyl group, a 3-methyl-1-cyclopentenyl group, a 3-methyl-2-cyclopentenyl group, a 3-methyl-3-cyclopentenyl group, a 3-methyl-4-cyclopentenyl group, a 3-methyl-5-cyclopentenyl group, a 3-methylene-cyclopentyl group, a 1-cyclohexenyl group, a 2-cyclohexenyl group, and a 3-cyclohexenyl group, and are not limited thereto.

Specific examples of the optionally substituted aryl group include, but are not limited to, a phenyl group, a 2-methylphenyl group, a 3-methylphenyl group, a 4-methylphenyl group, a 2-chlorophenyl group, a 3-chlorophenyl group, a 4-chlorophenyl group, a 2-fluorophenyl group, a 3-fluorophenyl group, a 4-fluorophenyl group, a 4-methoxyphenyl group, a 4-ethoxyphenyl group, a 4-nitrophenyl group, a 4-cyanophenyl group, a 1-naphthyl group, a 2-naphthyl group, a biphenyl-4-yl group, a biphenyl-3-yl group, a biphenyl-2-yl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group.

Specific examples of the optionally substituted heteroaryl group include, but are not limited to, a 2-thienyl group, a 3-thienyl group, a 2-furanyl group, a 3-furanyl group, a 2-oxazolyl group, a 4-oxazolyl group, a 5-oxazolyl group, a 3-isoxazolyl group, a 4-isoxazolyl group, a 5-isoxazolyl group, a 2-thiazolyl group, a 4-thiazolyl group, a 5-thiazolyl group, a 3-isothiazolyl group, a 4-isothiazolyl group, and a 5-isothiazolyl group.

Hereinafter, specific examples of the structural unit represented by the formula (C1-1-1) will be given, but the structural unit is not limited thereto.

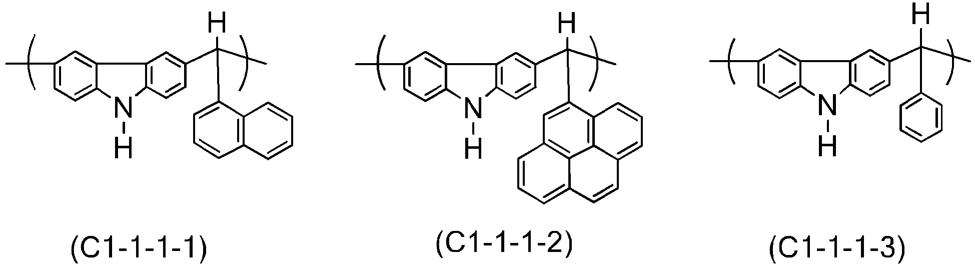

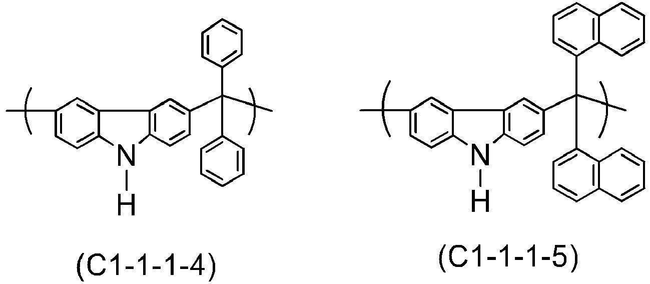

In a preferred embodiment, the novolac resin contains, for example, a structural unit represented by the following formula (C1-1-2) as the structural unit represented by the formula (C1-1).

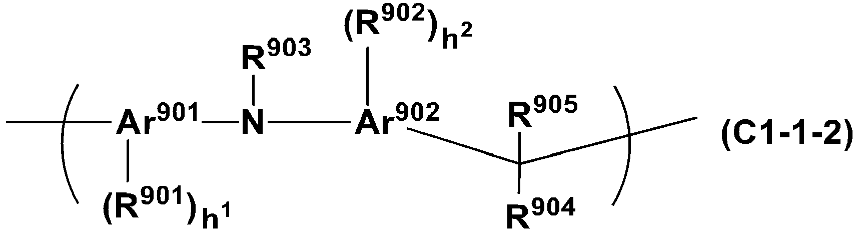

In the formula (C1-1-2), Ar⁹⁰¹ and Ar⁹⁰² each independently represent an aromatic ring such as a benzene ring or a naphthalene ring, and R⁹⁰¹ to R⁹⁰⁵ and h¹ and h² represent the same meaning as described above.

Hereinafter, specific examples of the structural unit represented by the formula (C1-1-2) will be given, but the structural unit is not limited thereto.

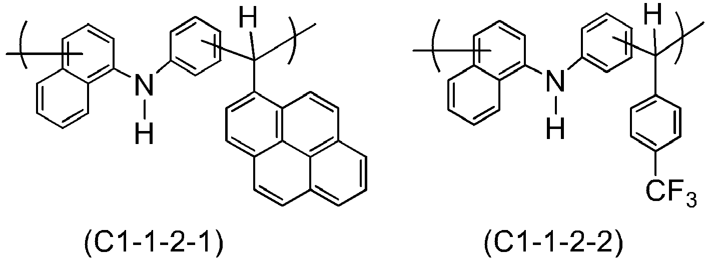

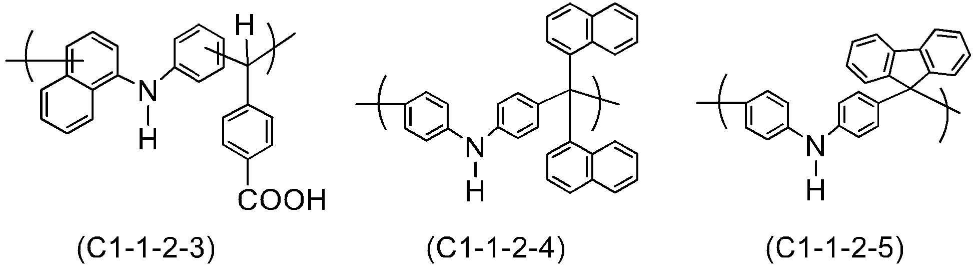

In a preferred embodiment, the novolac resin contains, for example, a structural unit represented by the following formula (C1-2-1) or (1-2-2) as the structural unit represented by the formula (C1-2).

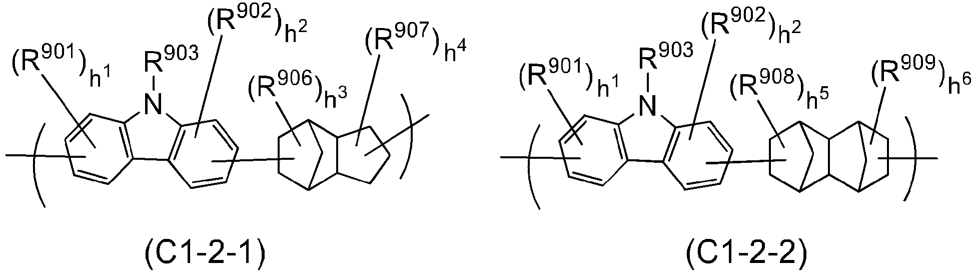

In the above formula, R⁹⁰⁶ to R⁹⁰⁹ are substituents bonded to the rings, and each independently represent a halogen atom, a nitro group, a cyano group, an amino group, a hydroxy group, a carboxy group, an optionally substituted alkyl group, an optionally substituted alkenyl group, or an optionally substituted aryl group. Specific examples and suitable numbers of carbon atoms of the halogen atom, the optionally substituted alkyl group, the optionally substituted alkenyl group, and the optionally substituted aryl group are the same as those described above, h³ to h⁶ each independently represent an integer of 0 to 3, and R⁹⁰¹ to R⁹⁰³ and h¹ and h² each represent the same meaning as described above.

Specific examples of the structural units represented by the formulae (C1-2-1) and (C1-2-2) will be given below, but the structural units are not limited thereto.

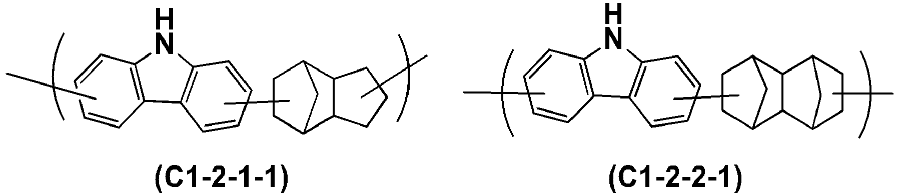

Hereinafter, specific examples of the structural unit represented by the formula (C1-3) will be given, but the structural unit is not limited thereto.

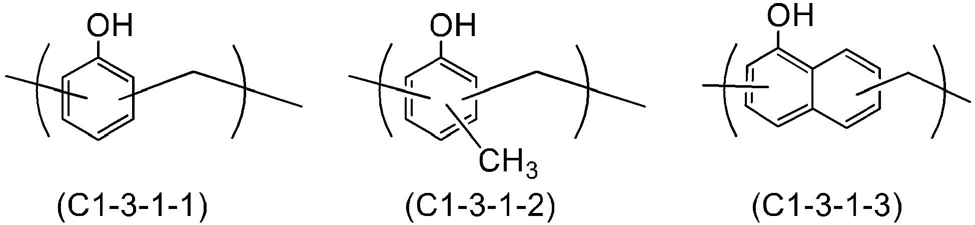

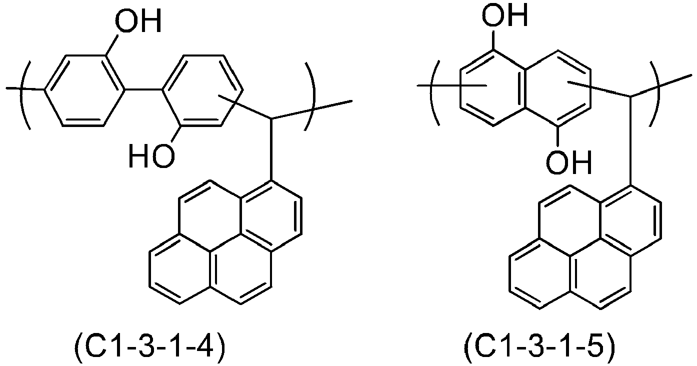

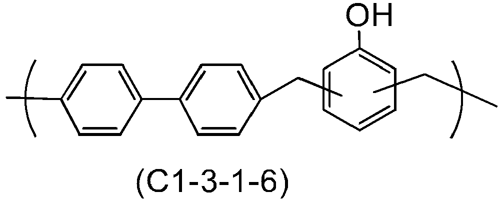

As described above, the novolac resin is, for example, a resin obtained by condensation reaction of at least one of a phenolic compound, a carbazole compound, and an aromatic amine compound with at least one of an aldehyde compound, a ketone compound, and a divinyl compound under an acid catalyst.

In this condensation reaction, for example, the aldehyde compound or the ketone compound is usually used in a ratio of 0.1 to 10 equivalents to 1 equivalent of the benzene ring constituting the ring of the carbazole compound.

In the condensation reaction, an acid catalyst is usually used.

Examples of the acid catalyst include mineral acids such as sulfuric acid, phosphoric acid, and perchloric acid, organic sulfonic acids such as p-toluenesulfonic acid and p-toluenesulfonic acid monohydrate, and carboxylic acids such as formic acid and oxalic acid, but are not limited thereto.

The amount of the acid catalyst is appropriately determined depending on the type of the acid to be used and the like, and thus cannot be generally defined, but is usually appropriately determined from the range of 0.001 to 10000 parts by mass with respect to 100 parts by mass of the carbazole compound.

When either the raw material compound or the acid catalyst to be used is a liquid, the condensation reaction can be performed without using a solvent in some cases, but is usually performed using a solvent.

Such a solvent is not particularly limited as long as the reaction is not inhibited, but typically, examples thereof include ether compounds such as cyclic ether compounds such as tetrahydrofuran and dioxane.

The reaction temperature is usually appropriately determined from the range of 40 to 200°C, and the reaction time cannot be generally specified because it varies depending on the reaction temperature, but is usually appropriately determined from the range of 30 minutes to 50 hours.

After completion of the reaction, if necessary, purification and isolation are performed according to a conventional method, and the obtained novolac resin is used for preparation of the release agent composition.

Those skilled in the art can determine the production conditions of the novolac resin without an excessive burden based on the above description and the common general technical knowledge, and therefore can produce the novolac resin.

The weight average molecular weight of the organic resin such as a novolac resin is usually 500 to 200,000, and is preferably 100,000 or less, more preferably 50,000 or less, still more preferably 10,000 or less, still more preferably 5,000 or less, and still more preferably 3,000 or less from the viewpoint of ensuring solubility in a solvent, and from the viewpoint of favorably mixing with a branched polysilane when forming a film to obtain a uniform film, and is preferably 600 or more, more preferably 700 or more, still more preferably 800 or more, still more preferably 900 or more, and still more preferably 1,000 or more from the viewpoint of improving the strength of the film.

In the present invention, the weight average molecular weight, the number average molecular weight, and the dispersity of the organic resins, such as a novolac resin, can be measured, for example, using a GPC apparatus (EcoSEC, HLC-8320GPC; manufactured by Tosoh Corporation) and a GPC column (TSKgel SuperMultipore HZ-N and TSKgel SuperMultipore HZ-H; manufactured by Tosoh Corporation), at a column temperature of 40°C, using tetrahydrofuran as an eluent (elution solvent), at a flow amount (flow rate) of 0.35 mL/min, and using polystyrene (manufactured by Sigma-Aldrich Co. LLC) as a standard sample.

The organic resin contained in the release agent composition is preferably a novolac resin, and therefore the release agent composition preferably contains a novolac resin alone as the organic resin, but may contain other polymers together with the novolac resin for the purpose of adjusting film physical properties and the like.

Examples of such other polymers include a polyacrylic acid ester compound, a polymethacrylic acid ester compound, a polyacrylamide compound, a polymethacrylamide compound, a polyvinyl compound, a polystyrene compound, a polymaleimide compound, a polymaleic anhydride, and a polyacrylonitrile compound.

The content of the novolac resin in the release agent composition is not particularly limited, but is preferably 70 mass% or more with respect to the total amount of the polymer contained in the release agent composition.

The content of the novolac resin in the release agent composition is not particularly limited, but is preferably 50 to 100 mass% with respect to the film constituent components. In the present invention, the term "film constituent components" means components other than a solvent contained in the composition.

### <<<Polynuclear phenol derivative>>>

The polynuclear phenol derivative is represented by, for example, the following formula (P). 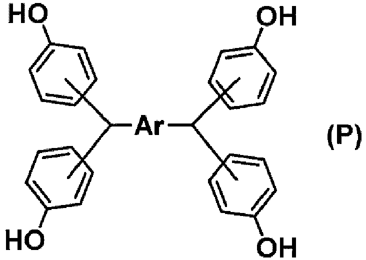 In the formula (P), Ar represents an arylene group, and the number of carbon atoms thereof is not particularly limited, but is usually 6 to 60, and is preferably 30 or less, more preferably 20 or less, still more preferably 18 or less, and still more preferably 12 or less from the viewpoint of preparing a release agent composition excellent in uniformity and obtaining a release layer having higher flatness with good reproducibility.

Specific examples of such an arylene group include: a 1,2-phenylene group, a 1,3-phenylene group, and a 1,4-phenylene group; groups derived by removing two hydrogen atoms on the aromatic ring of a fused ring aromatic hydrocarbon compound such as a 1,5-naphthalenediyl group, a 1,8-naphthalenediyl group, a 2,6-naphthalenediyl group, a 2,7-naphthalenediyl group, a 1,2-anthracenediyl group, a 1,3-anthracenediyl group, a 1,4-anthracenediyl group, a 1,5-anthracenediyl group, a 1,6-anthracenediyl group, a 1,7-anthracenediyl group, a 1,8-anthracenediyl group, a 2,3-anthracenediyl group, a 2,6-anthracenediyl group, a 2,7-anthracenediyl group, a 2,9-anthracenediyl group, a 2,10-anthracenediyl group, and a 9,10-anthracenediyl group; and a group derived by removing two hydrogen atoms on the aromatic rings of a ring-linked aromatic hydrocarbon compound such as a biphenyl-4,4'-diyl group and a paraterphenyl-4,4"-diyl group, but are not limited thereto.

The polynuclear phenol derivative represented by the formula (P) is preferably a polynuclear phenol derivative represented by the formula (P-1), more preferably a polynuclear phenol derivative represented by the formula (P-1-1), and still more preferably a polynuclear phenol derivative represented by the formula (P1) from the viewpoint of reproducibly obtaining a laminate that has the release layer exhibiting good releasability and can favorably separate the support substrate.

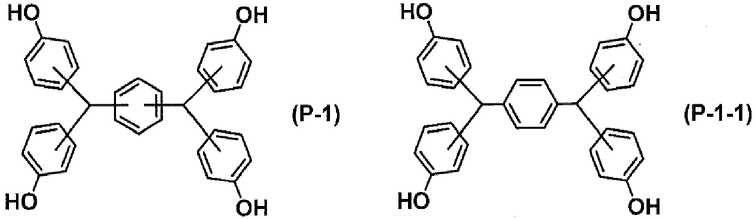

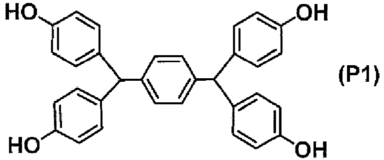

The content of the polynuclear phenol derivative in the release agent composition is not particularly limited, but is preferably 50 to 100 mass% with respect to the film constituent components.

### <<<Branched polysilane>>

The release agent composition may contain a branched polysilane.

The branched polysilane has a Si-Si bond and a branched structure. Since the branched polysilane is contained in the release agent composition, the release layer formed of the obtained film cannot be suitably removed by any of an organic solvent, an acid, and a chemical solution (alkali developer, hydrogen peroxide water, and the like) used in the production of a semiconductor element, but can be suitably removed by a cleaning agent composition. As a result, the residues of the release layer on the substrate can be suitably removed by cleaning each substrate with the cleaning agent composition after separating the semiconductor substrate and the support substrate of the laminate. Although the reason for this is not clear, depending on the type of the terminal group (terminal substituent (atom)) of the polysilane, the polysilane can be crosslinked by reacting with the organic resin, and the branched polysilane has more terminal groups (terminal substituent (atom)) than the linear polysilane. Therefore, it is considered that the branched polysilane has more crosslinking points than the linear polysilane, and it is presumed that both the property that the branched polysilane is not suitably removed by an organic solvent, an acid, or a chemical liquid (alkali developer, hydrogen peroxide water, and the like) used in the production of a semiconductor element and the property that the branched polysilane is suitably removed by a cleaning agent composition can be realized by appropriate and suitable curing through such more crosslinking points in the branched polysilane.

The branched polysilane preferably contains a structural unit represented by the formula (B).

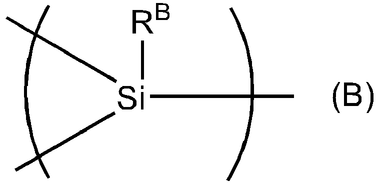

In the formula (B), R^{B} represents a hydrogen atom, a hydroxy group, a silyl group, or an organic group, and specific examples of such an organic group include a hydrocarbon group (an optionally substituted alkyl group, an optionally substituted alkenyl group, an optionally substituted aryl group, and an optionally substituted aralkyl group) and an ether group corresponding to these hydrocarbon groups (an optionally substituted alkoxy group, an optionally substituted aryloxy group, an optionally substituted aralkyloxy group, and the like), and the organic group is usually a hydrocarbon group such as an alkyl group, an alkenyl group, an aryl group, or an aralkyl group in many cases. In addition, a hydrogen atom, a hydroxy group, an alkoxy group, a silyl group, or the like is often substituted at the terminal.

The optionally substituted alkyl group may be linear, branched, or cyclic.

Specific examples of the linear or branched and optionally substituted alkyl group include a methyl group, an ethyl group, a n-propyl group, an i-propyl group, a n-butyl group, an i-butyl group, a s-butyl group, a tertiary butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, but are not limited thereto. The number of carbon atoms thereof is usually 1 to 14, preferably 1 to 10, and more preferably 1 to 6.

Specific examples of the cyclic and optionally substituted alkyl group include: cycloalkyl groups, such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and bicycloalkyl groups, such as a bicyclobutyl group, a bicyclopentyl group, a bicyclohexyl group, a bicycloheptyl group, a bicyclooctyl group, a bicyclononyl group, and a bicyclodecyl group, but are not limited thereto. The number of carbon atoms thereof is usually 3 to 14, preferably 4 to 10, and more preferably 5 to 6.

The alkenyl group may be linear, branched, or cyclic.

Specific examples of the linear or branched and optionally substituted alkenyl group include a vinyl group, an allyl group, a butenyl group, and a pentenyl group, and are not limited thereto. The number of carbon atoms thereof is usually 2 to 14, preferably 2 to 10, and more preferably 1 to 6.

Specific examples of the cyclic and optionally substituted alkenyl group include, but are not limited to, cyclopentenyl and cyclohexenyl. The number of carbon atoms thereof is usually 4 to 14, preferably 5 to 10, and more preferably 5 to 6.

Specific examples of the optionally substituted aryl group include a phenyl group, a 4-methylphenyl group, a 3-methylphenyl group, a 2-methylphenyl group, a 3,5-dimethylphenyl group, a 1-naphthyl group, and a 2-naphthyl group, but are not limited thereto, and the number of carbon atoms thereof is usually 6 to 20, preferably 6 to 14, and more preferably 6 to 12.

Specific examples of the optionally substituted aralkyl group include a benzyl group, a phenethyl group, and a phenylpropyl group, but are not limited thereto. The optionally substituted aralkyl group is preferably a group in which one of hydrogen atoms of an alkyl group having 1 to 4 carbon atoms is substituted with an aryl group having 6 to 20 carbon atoms.

In the optionally substituted alkoxy group, the alkyl moiety may be linear, branched, or cyclic.

Specific examples of the linear or branched and optionally substituted alkoxy group include a methoxy group, an ethoxy group, a propoxy group, an isopropoxy group, a butoxy group, a t-butoxy group, and a pentyloxy group, but are not limited thereto, and the number of carbon atoms thereof is usually 1 to 14, preferably 1 to 10, and more preferably 1 to 6.

Specific examples of the cyclic and optionally substituted alkoxy group include, but are not limited to, cyclopentyloxy and cyclohexyloxy, and the number of carbon atoms thereof is usually 3 to 14, preferably 4 to 10, and more preferably 5 to 6.

Specific examples of the optionally substituted aryloxy group include, but are not limited to, phenoxy, 1-naphthyloxy, and 2-naphthyloxy, and the number of carbon atoms thereof is usually 6 to 20, preferably 6 to 14, and more preferably 6 to 10.

Specific examples of the optionally substituted aralkyloxy group include benzyloxy, phenethyloxy, and phenylpropyloxy, but are not limited thereto. The optionally substituted aralkyloxy group is preferably a group in which one of the hydrogen atoms of an alkyloxy group having 1 to 4 carbon atoms is substituted with an aryl group having 6 to 20 carbon atoms.

Specific examples of the silyl group include a silyl group, a disilanyl group, and a trisilanyl group, but are not limited thereto, and the number of silicon atoms thereof is usually 1 to 10 and preferably 1 to 6.

When R^{B} is the organic group or the silyl group, at least one of the hydrogen atoms may be substituted with a substituent. Specific examples of such a substituent include a hydroxy group, an alkyl group, an aryl group, and an alkoxy group.

From the viewpoint of suppressing unintentional peeling when the laminate is brought into contact with any of an organic solvent, an acid, and a chemical liquid (alkali developer, hydrogen peroxide water, and the like) used in the production of a semiconductor element, from the viewpoint of suitably removing a residue of a release layer on a substrate in a case where the semiconductor substrate and the support substrate of the laminate are separated and then each substrate is washed with a cleaning agent composition, and the like, R^{B} is preferably an alkyl group or an aryl group, more preferably an aryl group, still more preferably a phenyl group, a 1-naphthyl group, or a 2-naphthyl group, and still more preferably a phenyl group.

The branched polysilane may contain a structural unit represented by the following formula (S) or a structural unit represented by the following formula (N) together with the structural unit represented by the formula (B). From the viewpoint of suppressing unintentional peeling when the laminate is brought into contact with any of an organic solvent, an acid, and a chemical liquid (alkali developer, hydrogen peroxide water, and the like) used in the production of a semiconductor element, from the viewpoint of suitably removing a residue of a release layer on a substrate in a case where the semiconductor substrate and the support substrate of the laminate are separated and then each substrate is washed with a cleaning agent composition, and the like, the content of the structural unit represented by the formula (B) in the branched polysilane is usually 50 mol% or more, preferably 60 mol% or more, more preferably 70 mol% or more, still more preferably 80 mol% or more, further more preferably 90% or more, further still more preferably 95 mol% or more, among all the structural units. 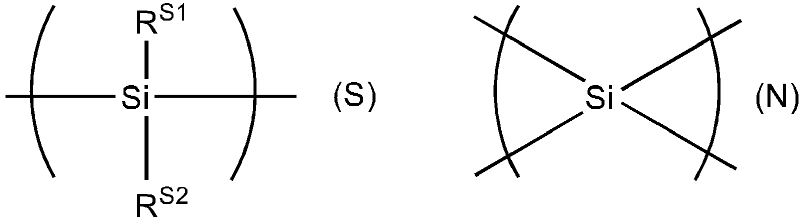 (R^{S1} and ^{S2} represent the same meaning as R^{B}.)

The terminal group (terminal substituent (atom)) of the branched polysilane may be usually a hydrogen atom, a hydroxy group, a halogen atom (chlorine atom or the like), an alkyl group, an aryl group, an alkoxy group, a silyl group, or the like. Among them, a hydroxy group, a methyl group, and a phenyl group are often used, and a methyl group is particularly preferable, and the terminal group may be a trimethylsilyl group.

In one embodiment, the average polymerization degree of the branched polysilane is usually 2 to 100, preferably 3 to 80, more preferably 5 to 50, and still more preferably 10 to 30 in terms of silicon atoms (that is, the average number of silicon atoms per molecule).

In one embodiment, the upper limit of the weight average molecular weight of the branched polysilane is usually 30,000, preferably 20,000, more preferably 10,000, still more preferably 5,000, still more preferably 2,000, and still more preferably 1,500, and the lower limit thereof is usually 50, preferably 100, more preferably 150, still more preferably 200, still more preferably 300, and still more preferably 500.

The average polymerization degree and the weight average molecular weight of the branched polysilane can be measured, for example, using a GPC apparatus (EcoSEC, HLC-8220GPC; manufactured by Tosoh Corporation) and a GPC column (Shodex KF-803L, KF-802, and KF-801, which are manufactured by Showa Denko K.K., are used in this order.), at a column temperature of 40°C, using tetrahydrofuran as an eluent (elution solvent), at a flow amount (flow rate) of 1.00 mL/min, and using polystyrene (manufactured by Sigma-Aldrich Co. LLC) as a standard sample.

If the polymerization degree and the weight average molecular weight of the branched polysilane to be used are too small, there is a possibility that the branched polysilane is vaporized by heating at the time of forming a film as the release layer or at the time of processing the obtained laminate including the release layer, or defects due to poor strength of the film may occur. If the polymerization degree and the molecular weight of the branched polysilane to be used are too large, sufficient solubility cannot be secured and precipitation may occur in the composition depending on the type of solvent to be used for preparing the release agent composition, or mixing with a resin may be insufficient, and a highly uniform film cannot be obtained with high reproducibility.

Therefore, it is desirable that the polymerization degree and the weight average molecular weight of the branched polysilane satisfy the above-described ranges from the viewpoint of obtaining a laminate including a release layer contributing to suitable production of a semiconductor element with higher reproducibility.

The 5% weight loss temperature of the branched polysilane is usually 300°C or higher, preferably 350°C or higher, more preferably 365°C or higher, still more preferably 380°C or higher, still more preferably 395°C or higher, and still more preferably 400°C or higher from the viewpoint of reproducibly obtaining a release layer excellent in heat resistance.

The 5% weight loss temperature of the branched polysilane can be measured by, for example, raising the temperature from normal temperature (25°C) to 400°C at 10°C/min under air using 2010SR, which is manufactured by NETZSCH.

From the viewpoint of suitably removing a residue of a release layer on a substrate in a case where the semiconductor substrate and the support substrate of the laminate are separated and then each substrate is washed with a cleaning agent composition, from the viewpoint of preparing a release agent composition excellent in uniformity with high reproductivity, and the like, the branched polysilane is preferably dissolved in any of an ether compound such as tetrahydrofuran, an aromatic compound such as toluene, a glycol ether ester compound such as propylene glycol monomethyl ether acetate, a ketone compound such as cyclohexanone or methyl ethyl ketone, and a glycol ether compound such as propylene glycol monomethyl ether. The dissolution in this case means a case where dissolution within 1 hour can be visually confirmed when dissolution is attempted using a shaker at normal temperature (25°C) so as to be a 10 mass% solution.

The branched polysilane may be either solid or liquid at normal temperature.

The branched polysilane can be produced with reference to a known method described in, for example, JP 2011-208054 A, JP 2007-106894 A, JP 2007-145879 A, and WO 2005/113648 A1, or can be obtained as a commercial product. Specific examples of the commercially available product include, but are not limited to, silicon materials manufactured by Osaka Gas Chemicals Co., Ltd., polysilanes OGSOL SI-20-10 and SI-20-14.

Suitable examples of the branched polysilane include, but are not limited to, the following. 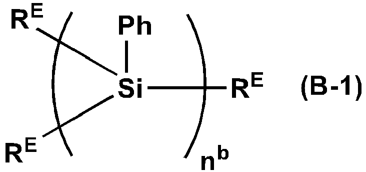 (Ph represents a phenyl group, R^{E} each independently represents a terminal substituent and represents an atom or a group, and n^{b} represents the number of repeating units.)

The content of the branched polysilane in the release agent composition is usually 10 to 90 amount% with respect to the film constituent components. From the viewpoint of reproducibly realizing a film that cannot be suitably removed by an organic solvent, an acid, or a chemical liquid (alkali developer, hydrogen peroxide water, and the like) used in the production of a semiconductor element but can be suitably removed by a cleaning agent composition, the content is preferably 15 to 80 mass%, more preferably 20 to 70 mass%, still more preferably 25 to 60 mass%, and still more preferably 30 to 50 mass%.

### <<<Crosslinking agent>>>

The release agent composition may contain a crosslinking agent.

The crosslinking agent may cause a crosslinking reaction by self-condensation, but when a crosslinkable substituent is present in the novolac resin, the crosslinking agent can cause a crosslinking reaction with the crosslinkable substituent.

Specific typical examples of the crosslinking agent include, but are not particularly limited to, a phenol-based crosslinking agent, a melamine-based crosslinking agent, a urea-based crosslinking agent, a thiourea-based crosslinking agent, and the like having a crosslinking group such as a hydroxymethyl group and an alkoxymethyl group such as a methoxymethyl group and a butoxymethyl group in the molecule. These may be a low-molecular-weight compound or a polymer compound.

The crosslinking agent contained in the release agent composition usually has two or more crosslinking groups. From the viewpoint of reproducibly realizing more suitable curing, the number of crosslinking groups contained in the compound as the crosslinking agent is preferably 2 to 10, and more preferably 2 to 6.

The crosslinking agent contained in the release agent composition preferably has an aromatic ring (for example, a benzene ring or a naphthalene ring) in the molecule from the viewpoint of achieving higher heat resistance, and typical examples of such a crosslinking agent include, but are not limited to, phenolic crosslinking agents.

The phenolic crosslinking agent having a crosslinking group is a compound having a crosslinking group bonded to an aromatic ring and having at least one of a phenolic hydroxyl group and an alkoxy group derived from a phenolic hydroxyl group. Examples of such an alkoxy group derived from a phenolic hydroxyl group include a methoxy group and a butoxy group, but are not limited thereto.

The aromatic ring to which the crosslinking group is bonded and the aromatic ring to which the phenolic hydroxyl group and/or the alkoxy group derived from a phenolic hydroxyl group is bonded are not limited to a non-condensed aromatic ring such as a benzene ring, and may be a condensed aromatic ring, such as a naphthalene ring and anthracene.

When a plurality of aromatic rings is present in the molecule of the phenolic crosslinking agent, the crosslinking group and the phenolic hydroxyl group and the alkoxy group derived from a phenolic hydroxyl group may be bonded to the same aromatic ring in the molecule or may be bonded to different aromatic rings.

The aromatic ring to which the crosslinking group and the phenolic hydroxyl group and the alkoxy group derived from a phenolic hydroxyl group are bonded may be further substituted with: a hydrocarbon group such as an alkyl group such as a methyl group, an ethyl group, or a butyl group; and an aryl group such as a phenyl group; a halogen atom such as a fluorine atom; or the like.

For example, specific examples of the phenolic crosslinking agent having a crosslinking group include compounds represented by any of formulae (L1) to (L4): 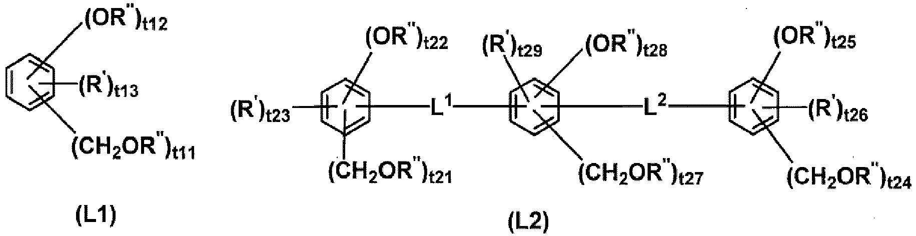 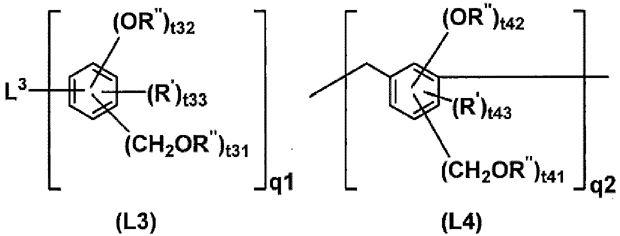 wherein each R' independently represents a fluorine atom, an aryl group, or an alkyl group, each R" independently represents a hydrogen atom or an alkyl group, L¹ and L² each independently represent a single bond, a methylene group, or a propane-2,2-diyl group, L³ is determined according to q1 and represents a single bond, a methylene group, a propane-2,2-diyl group, a methantriyl group, or an ethane-1,1,1-triyl group, t11, t12, and t13 are integers satisfying 2 ≤ t11 ≤ 5, 1 ≤ t12 ≤ 4, 0 ≤ t13 ≤ 3, and t11 + t12 + t13 ≤ 6, t21, t22, and t23 are integers satisfying 2 ≤ t21 ≤ 4, 1 ≤ t22 ≤ 3, 0 ≤ t23 ≤ 2, and t21 + t22 + t23 ≤ 5, t24, t25, and t26 are integers satisfying 2 ≤ t24 ≤ 4, 1 ≤ t25 ≤ 3, 0 ≤ t26 ≤ 2, and t24 + t25 + t26 ≤ 5, t27, t28, and t29 are integers satisfying 0 ≤ t27 ≤ 4, 0 ≤ t28 ≤ 4, 0 ≤ t29 ≤ 4, and t27 + t28 + t29 ≤ 4, t31, t32, and t33 are integers satisfying 2 ≤ t31 ≤ 4, 1 ≤ t32 ≤ 3, 0 ≤ t33 ≤ 2, and t31 + t32 + t33 ≤ 5, t41, t42, and t43 are integers satisfying 2 ≤ t41 ≤ 3, 1 ≤ t42 ≤ 2, 0 ≤ t43 ≤ 1, and t41 + t42 + t43 ≤ 4, q1 is 2 or 3, q2 represents the number of repetitions and is an integer of 0 or more, and specific examples of the aryl group and the alkyl group include those same as the following specific examples, and the aryl group is preferably a phenyl group, and the alkyl group is preferably a methyl group or a t-butyl group.

Specific examples of the compounds represented by the formulae (L1) to (L4) are given below, but the compounds are not limited thereto. These compounds may be synthesized by a known method, and can also be obtained, for example, as a product from ASAHI YUKIZAI KOGYO or Honshu Chemical Industry Co., Ltd.

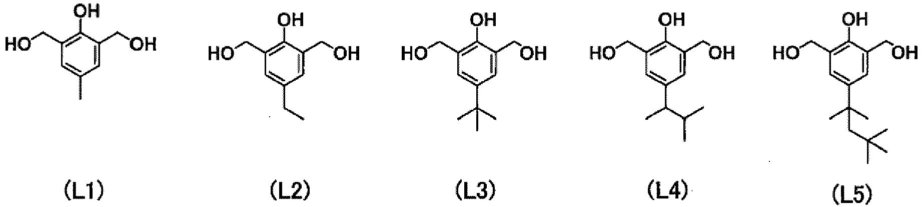

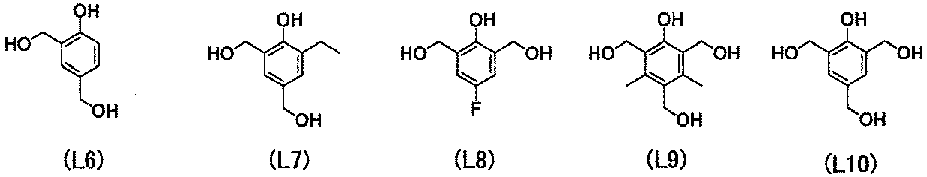

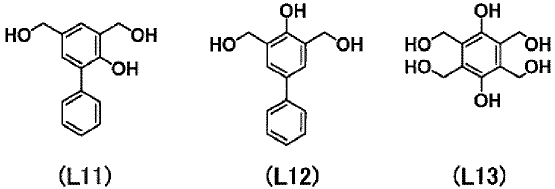

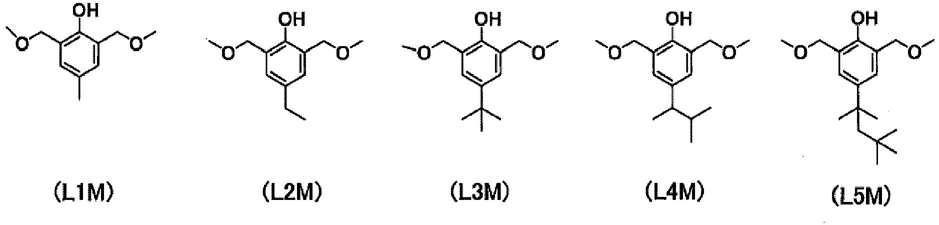

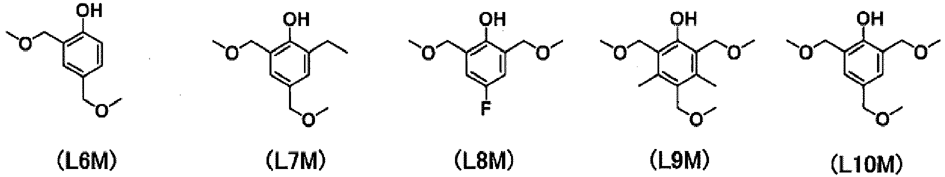

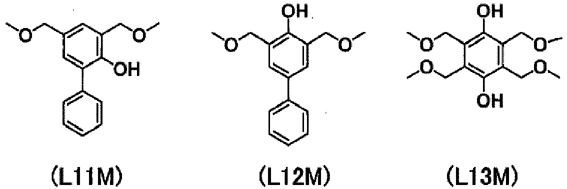

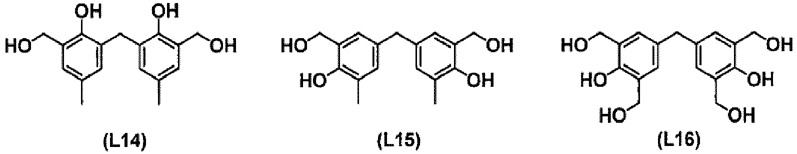

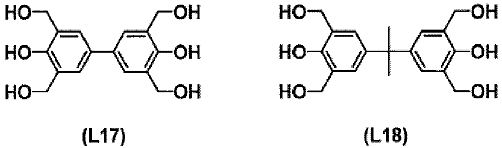

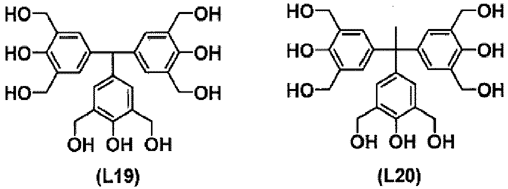

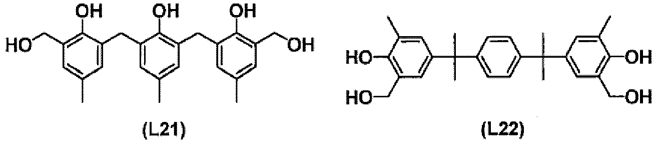

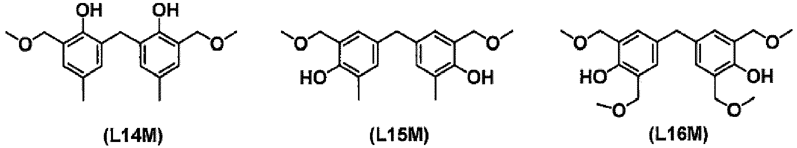

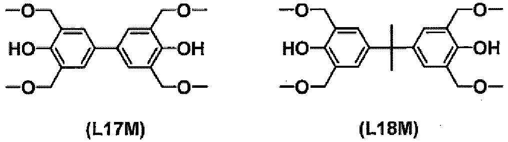

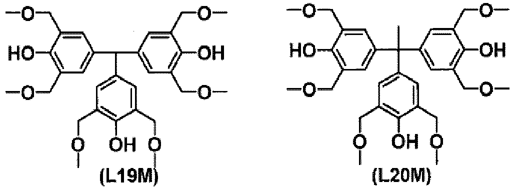

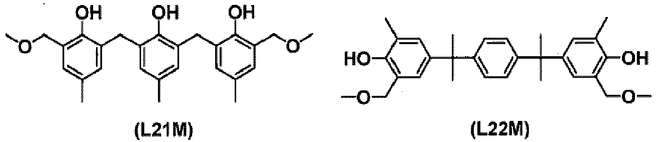

The melamine-based crosslinking agent having a crosslinking group is a melamine derivative, a 2,4-diamino -1,3,5-triazine derivative, or a 2-amino-1,3,5-triazine derivative in which at least one of the hydrogen atoms of an amino group bonded to the triazine ring thereof is substituted with a crosslinking group, and the triazine ring may further have a substituent such as an aryl group such as a phenyl group.

Specific examples of the melamine-based crosslinking agent having a crosslinking group include, but are not limited to, mono, bis, tris, tetrakis, pentakis, or hexakis alkoxymethylmelamine, such as N,N,N',N',N",N"-hexakis(methoxymethyl)melamine and N,N,N',N',N",N"-hexakis(butoxymethyl)melamine, and mono, bis, tris, or tetrakis alkoxymethylbenzoguanamine, such as N,N,N',N'-tetrakis(methoxymethyl)benzoguanamine and N,N,N',N'-tetrakis(butoxymethyl)benzoguanamine.

The urea-based crosslinking agent having a crosslinking group is a derivative of a urea bond-containing compound, and has a structure in which at least one of the hydrogen atoms of the NH groups constituting a urea bond is substituted with a crosslinking group.

Specific examples of the urea-based crosslinking agent having a crosslinking group include: mono, bis, tris, or tetrakis alkoxymethylglycoluril, such as 1,3,4,6-tetrakis(methoxymethyl)glycoluril and 1,3,4,6-tetrakis(butoxymethyl)glycoluril; mono, bis, tris, or tetrakis alkoxymethylurea, such as 1,3-bis(methoxymethyl)urea and 1,1,3,3-tetrakis methoxymethylurea; and the like, but are not limited thereto.

The thiourea-based crosslinking agent having a crosslinking group is a derivative of a thiourea bond-containing compound, and has a structure in which at least one of the hydrogen atoms of the NH groups constituting a thiourea bond is substituted with a crosslinking group.

Specific examples of the thiourea-based crosslinking agent having a crosslinking group include mono, bis, tris, or tetrakis alkoxymethylthiourea, such as 1,3-bis (methoxymethyl)thiourea and 1,1,3,3-tetrakis methoxymethylthiourea, but are not limited thereto.

The amount of the crosslinking agent contained in the release agent composition varies depending on the coating method to be employed, the desired film thickness, and the like, and thus cannot be generally defined, and is usually 0.01 to 50 mass% with respect to the organic resin or the polynuclear phenol derivative. From the viewpoint of realizing suitable curing and reproducibly obtaining the laminate in which the semiconductor substrate and the support substrate can be satisfactorily separated, the amount is preferably 0.1 mass% or more, more preferably 1 mass% or more, still more preferably 3 mass% or more, still more preferably 5 mass% or more, and preferably 45 mass% or less, more preferably 40 mass% or less, still more preferably 35 mass% or less, still more preferably 30 mass% or less.

### <<<Acid generator and acid>>>

For the purpose of promoting the crosslinking reaction, the release agent composition may contain an acid generator or an acid.

Examples of the acid generator include a thermal acid generator and a photoacid generator.

The thermal acid generator is not particularly limited as long as an acid is generated by heat, and specific examples thereof include 2,4,4,6-tetrabromocyclohexadienone, benzoin tosylate, 2-nitrobenzyl tosylate, K-PURE [registered trademark] CXC-1612, K-PURE CXC-1614, K-PURE TAG-2172, K-PURE TAG-2179, K-PURE TAG-2678, K-PURE TAG2689, and K-PURE TAG2700 (manufactured by King Industries, Inc.), SI-45, SI-60, SI-80, SI-100, SI-110, and SI-150 (manufactured by SANSHIN CHEMICAL INDUSTRY CO.,LTD.), and other organic sulfonic acid alkyl esters, but are not limited thereto.

Examples of the photoacid generator include an onium salt compound, a sulfonimide compound, and a disulfonyldiazomethane compound.

Specific examples of the onium salt compound include iodonium salt compounds such as diphenyliodonium hexafluorophosphate, diphenyliodonium trifluoromethanesulfonate, diphenyliodonium nonafluoronormal butanesulfonate, diphenyliodonium perfluoronormal octanesulfonate, diphenyliodonium camphor sulfonate, bis(4-tert-butylphenyl)iodonium camphor sulfonate, and bis(4-tert-butylphenyl)iodonium trifluoromethanesulfonate; and sulfonium salt compounds such as triphenylsulfonium nitrate, triphenylsulfonium hexafluoroantimonate, triphenylsulfonium nonafluoronormal butanesulfonate, triphenylsulfonium camphor sulfonate, and triphenylsulfonium trifluoromethanesulfonate, but are not limited thereto.

Specific examples of the sulfonimide compound include N-(trifluoromethanesulfonyloxy)succinimide, N-(nonafluoronormalbutanesulfonyloxy)succinimide, N-(camphorsulfonyloxy)succinimide, and N-(trifluoromethanesulfonyloxy)naphthalimide, but are not limited thereto.

Specific examples of the disulfonyl diazomethane compound include bis(trifluoromethylsulfonyl) diazomethane, bis(cyclohexylsulfonyl) diazomethane, bis(phenylsulfonyl) diazomethane, bis(p-toluenesulfonyl) diazomethane, bis(2,4-dimethylbenzenesulfonyl) diazomethane, methylsulfonyl-p-toluenesulfonyl diazomethane, and the like, but are not limited thereto.

Specific examples of the acid include arylsulfonic acids and pyridinium salts, such as p-toluenesulfonic acid, pyridinium p-toluenesulfonic acid (pyridinium p-toluenesulfonate), pyridinium trifluoromethanesulfonate, pyridinium phenolsulfonic acid, 5-sulfosalicylic acid, 4-phenolsulfonic acid, 4-chlorobenzenesulfonic acid, benzenedisulfonic acid, and 1-naphthalenesulfonic acid, and salts thereof; arylcarboxylic acids, such as salicylic acid, benzoic acid, hydroxybenzoic acid, and naphthalenecarboxylic acid, and salts thereof; chain or cyclic alkylsulfonic acids, such as trifluoromethanesulfonic acid and camphorsulfonic acid, and salts thereof; and chain or cyclic alkylcarboxylic acids, such as citric acid, and salts thereof, but are not limited thereto.

The amount of the acid generator and the acid contained in the release agent composition cannot be generally specified since they vary depending on the type of the crosslinking agent to be used together, the heating temperature at the time of forming a film, and the like, and is usually 0.01 to 5 mass% with respect to the film constituent components.

### <<<Surfactant>>>

The release agent composition may contain a surfactant for the purpose of, for example, adjusting the liquid physical properties of the composition itself or the film physical properties of the resulting film, or reproducibly preparing a highly uniform release agent composition.

Examples of the surfactant include nonionic surfactants, such as: polyoxyethylene alkyl ethers, such as polyoxyethylene lauryl ether, polyoxyethylene stearyl ether, polyoxyethylene cetyl ether, and polyoxyethylene oleyl ether, polyoxyethylene alkyl allyl ethers, such as polyoxyethylene octyl phenol ether and polyoxyethylene nonyl phenol ether, polyoxyethylene/polyoxypropylene block copolymers, sorbitan fatty acid esters, such as sorbitan monolaurate, sorbitan monopalmitate, sorbitan monostearate, sorbitan monooleate, sorbitan trioleate, and sorbitan tristearate, and polyoxyethylene sorbitan fatty acid esters, such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants, such as EFUTOP EF301, EF303, and EF352 (trade name, manufactured by TOKEM PRODUCTS), MEGAFACE F171, F173, R-30, and R-30N (trade name, manufactured by DIC Corporation), Fluorad FC430, FC431 (trade name, manufactured by Sumitomo 3M Limited), and AsahiGuard AG710, Surflon S-382, SC101, SC102, SC103, SC104, SC105, and SC106 (trade name, manufactured by Asahi Glass Co., Ltd.); and KP341, an organosiloxane polymer (manufactured by Shin-Etsu Chemical Co., Ltd.).

The surfactant can be used singly or in combination of two or more kinds thereof.

The amount of the surfactant is usually 2 mass% or less with respect to the film constituent components of the release agent composition.

### <<<Solvent>>>

The release agent composition preferably contains a solvent.

As such a solvent, for example, a highly polar solvent capable of satisfactorily dissolving film constituent components such as the organic resin, the polynuclear phenol derivative, the branched polysilane, and the crosslinking agent can be used. As necessary, a low polar solvent may be used for the purpose of adjusting viscosity, surface tension, and the like. In the present invention, it is defined that the low polar solvent has a relative permittivity of less than 7 at a frequency of 100 kHz and the highly polar solvent has a relative permittivity of 7 or more at a frequency of 100 kHz. The solvent can be used singly or in combination of two or more kinds thereof.

Examples of the highly polar solvent include amide-based solvents, such as N,N-dimethylformamide, N,N-dimethylacetamide, N,N-dimethylisobutylamide, N-methylpyrrolidone, and 1,3-dimethyl-2-imidazolidinone; ketone-based solvents, such as ethyl methyl ketone, isophorone, and cyclohexanone; cyano-based solvents, such as acetonitrile and 3-methoxypropionitrile; polyhydric alcohol-based solvents, such as ethylene glycol, diethylene glycol, triethylene glycol, dipropylene glycol, 1,3-butanediol, and 2,3-butanediol;
monohydric alcohol-based solvents other than aliphatic alcohols, such as propyleneglycol monomethylether, diethyleneglycol monomethylether, diethyleneglycol monophenylether, triethyleneglycol monomethylether, dipropyleneglycol monomethylether, benzyl alcohol, 2-phenoxyethanol, 2-benzyloxyethanol, 3-phenoxybenzyl alcohol, and tetrahydrofurfuryl alcohol; and sulfoxide-based solvents, such as dimethyl sulfoxide.

Examples of the low polar solvent include chlorine-based solvents, such as chloroform and chlorobenzene; aromatic hydrocarbon-based solvents, such as alkylbenzenes, such as toluene, xylene, tetralin, cyclohexylbenzene, and decylbenzene; aliphatic alcohol-based solvents, such as 1-octanol, 1-nonanol, and 1-decanol; ether-based solvents, such as tetrahydrofuran, dioxane, anisole, 4-methoxytoluene, 3-phenoxytoluene, dibenzyl ether, diethyleneglycol dimethylether, diethyleneglycol butylmethylether, triethyleneglycol dimethylether, and triethyleneglycol butylmethylether; ester-based solvents, such as methyl benzoate, ethyl benzoate, butyl benzoate, isoamyl benzoate, bis(2-ethylhexyl) phthalate, dibutyl maleate, dibutyl oxalate, hexyl acetate, propyleneglycol monomethylether acetate, diethyleneglycol monoethylether acetate, and diethyleneglycol monobutylether acetate.

The content of the solvent is appropriately determined in consideration of the desired viscosity of the composition, the coating method to be adopted, the thickness of the film to be prepared, and the like, and is 99 mass% or less with respect to the entire composition, and preferably 70 to 99 mass% with respect to the entire composition. That is, the amount of the film constituent components in that case is 1 to 30 mass% with respect to the entire composition.

The viscosity and surface tension of the release agent composition are appropriately adjusted by changing the type of the solvent to be used, the ratio thereof, the concentration of the film constituent components, and the like in consideration of various factors such as the coating method to be used and the desired film thickness.

In an embodiment of the present invention, the release agent composition contains a glycol-based solvent from the viewpoint of reproducibly obtaining a highly uniform composition, from the viewpoint of reproducibly obtaining a composition with high storage stability, from the viewpoint of reproducibly obtaining a composition that provides a highly uniform film, and the like. The term "glycol-based solvent" as used herein is a generic term for glycols, glycol monoethers, glycol diethers, glycol monoesters, glycol diesters, and glycol ester ethers.

An example of a preferred glycol-based solvent is represented by the formula (G).

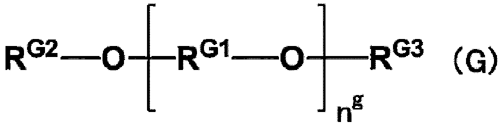

In the formula (G), R^{G1} each independently represents a linear or branched alkylene group having 2 to 4 carbon atoms, R^{G2} and R^{G3} each independently represent a hydrogen atom, a linear or branched alkyl group having 1 to 8 carbon atoms, or an alkylacyl group in which the alkyl moiety is a linear or branched alkyl group having 1 to 8 carbon atoms, and n^{g} is an integer of 1 to 6.

Specific examples of the linear or branched alkylene group having 2 to 4 carbon atoms include, but are not limited to, an ethylene group, a trimethylene group, a 1-methylethylene group, a tetramethylene group, a 2-methylpropane-1,3-diyl group, a pentamethylene group, and a hexamethylene group.

Among them, a linear or branched alkylene group having 2 to 3 carbon atoms is preferable, and a linear or branched alkylene group having three carbon atoms is more preferable from the viewpoint of reproducibly obtaining a highly uniform composition, from the viewpoint of reproducibly obtaining a composition with high storage stability, from the viewpoint of reproducibly obtaining a composition that provides a highly uniform film, and the like.

Specific examples of the linear or branched alkyl group having 1 to 8 carbon atoms include a methyl group, an ethyl group, a n-propyl group, an i-propyl group, a n-butyl group, an i-butyl group, a s-butyl group, a tertiary butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, but are not limited thereto.

Among them, a methyl group and an ethyl group are preferable, and a methyl group is more preferable from the viewpoint of reproducibly obtaining a highly uniform composition, from the viewpoint of reproducibly obtaining a composition with high storage stability, from the viewpoint of reproducibly obtaining a composition that provides a highly uniform film, and the like.

Specific examples of the linear or branched alkyl group having 1 to 8 carbon atoms in the alkylacyl group in which the alkyl moiety is a linear or branched alkyl group having 1 to 8 carbon atoms include the same as the specific examples described above.

Among them, a methylcarbonyl group and an ethylcarbonyl group are preferable, and a methylcarbonyl group is more preferable from the viewpoint of reproducibly obtaining a highly uniform composition, from the viewpoint of reproducibly obtaining a composition with high storage stability, from the viewpoint of reproducibly obtaining a composition that provides a highly uniform film, and the like.

n^{g} is preferably 4 or less, more preferably 3 or less, still more preferably 2 or less, and most preferably 1 from the viewpoint of reproducibly obtaining a highly uniform composition, from the viewpoint of reproducibly obtaining a composition with high storage stability, from the viewpoint of reproducibly obtaining a composition that provides a highly uniform film, and the like.

In the formula (G), preferably, at least one of R^{G2} and R^{G3} is a linear or branched alkyl group having 1 to 8 carbon atoms, more preferably, one of R^{G2} and R^{G3} is a linear or branched alkyl group having 1 to 8 carbon atoms, and the other is a hydrogen atom or an alkylacyl group in which the alkyl moiety is a linear or branched alkyl group having 1 to 8 carbon atoms, from the viewpoint of reproducibly obtaining a highly uniform composition, from the viewpoint of reproducibly obtaining a composition with high storage stability, from the viewpoint of reproducibly obtaining a composition that provides a highly uniform film, and the like.

The content of the glycol-based solvent is preferably 50 mass% or more, more preferably 70 mass% or more, still more preferably 80 mass% or more, still more preferably 90 mass% or more, and still more preferably 95 mass% or more, with respect to the solvent contained in the release agent composition, from the viewpoint of reproducibly obtaining a highly uniform composition, from the viewpoint of reproducibly obtaining a composition with high storage stability, from the viewpoint of reproducibly obtaining a composition that provides a highly uniform film, and the like.

In the release agent composition, the film constituent components are uniformly dispersed or dissolved in the solvent, and preferably dissolved, from the viewpoint of reproducibly obtaining a highly uniform composition, from the viewpoint of reproducibly obtaining a composition with high storage stability, from the viewpoint of reproducibly obtaining a composition that provides a highly uniform film, and the like.

The release agent composition can be produced, for example, by mixing the organic resin or the polynuclear phenol derivative, the solvent, and as necessary, the crosslinking agent.

The mixing order is not particularly limited, but examples of the method by which the release agent composition can be easily and reproducibly produced include, but are not limited to, a method in which the organic resin or the polynuclear phenol derivative and the crosslinking agent are dissolved at a time in the solvent, and a method in which a part of the organic resin or the polynuclear phenol derivative and the crosslinking agent is dissolved in the solvent, the rest is separately dissolved in the solvent, and each obtained solution is mixed with each other. When the release agent composition is prepared, heating may be appropriately performed as long as the components are not decomposed or altered.

In the present invention, for the purpose of removing foreign substances, a solvent, a solution, or the like to be used may be filtered using a filter or the like during the production of the release agent composition or after mixing all the components.

The thickness of the release layer is not particularly limited, but is usually 5 nm to 100 um, 10 nm to 10 um in one embodiment, 50 nm to 1 um in another embodiment, and 100 nm to 700 nm in still another embodiment.

The method for forming the release layer from the release agent composition is not particularly limited, and examples thereof include the method described in the method for producing a laminate described later.

The method for producing a laminate is not particularly limited, and examples thereof include the method for producing a laminate described later.

An example of the laminate of the present invention will be described with reference to a drawing.

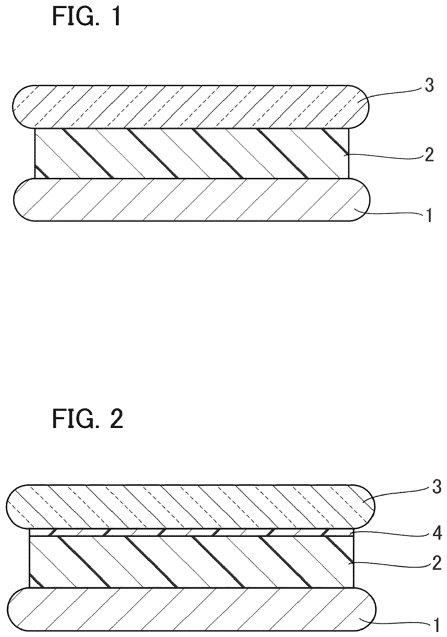

FIG. 1 is a schematic cross-sectional view of an example of the laminate.

The laminate of FIG. 1 includes a semiconductor substrate 1, an adhesive layer 2, and a support substrate 3 in this order.

The adhesive layer 2 is provided between the semiconductor substrate 1 and the support substrate 3. The adhesive layer 2 is in contact with the semiconductor substrate 1. The release layer 3 is in contact with the adhesive layer 2 and the support substrate 4.

FIG. 2 is a schematic cross-sectional view of another example of the laminate.

The laminate of FIG. 2 includes a semiconductor substrate 1, an adhesive layer 2, a release layer 4, and a support substrate 3 in this order.

The adhesive layer 2 and the release layer 4 are provided between the semiconductor substrate 1 and the support substrate 3. The adhesive layer 2 is in contact with the semiconductor substrate 1. The release layer 4 is in contact with the adhesive layer 2 and the support substrate 3.

When the laminate has a release layer, the arrangement of the adhesive layer and the release layer may be reverse to that in FIG. 2. In other words, when the laminate has a release layer, the release layer may be in contact with the semiconductor substrate, and the adhesive layer may be in contact with the release layer and the support substrate.

However, in a case where the semiconductor substrate and the support substrate are separated by light irradiation, it is preferable that the support substrate is optically transparent, and the release layer is provided between the adhesive layer and the support substrate.

### (Method for producing laminate)

The method for producing a laminate of the present invention includes an adhesive coating layer-forming step, a bonding step, and an adhesive layer-forming step, and further includes other steps as necessary.

The adhesive coating layer-forming step is a step in which the adhesive composition of the present invention is applied onto a semiconductor substrate or onto a support substrate to form an adhesive coating layer.

The bonding step is a step of bonding the semiconductor substrate and the support substrate to each other with the adhesive coating layer interposed therebetween.

The adhesive layer-forming step is a step in which the semiconductor substrate, the adhesive coating layer, and the support substrate are heated to form an adhesive layer from the adhesive coating layer.

### <Adhesive coating layer-forming step>

The adhesive coating layer-forming step is a step in which the adhesive composition of the present invention is applied onto a semiconductor substrate or onto a support substrate to form an adhesive coating layer.

Examples of a method of forming the adhesive coating layer from the adhesive composition include coating. The coating method is usually spin coating.

In addition, as another method of forming the adhesive coating layer from the adhesive composition, a method of separately forming a coating film from the adhesive composition by a spin coating method or the like and attaching the sheet-like coating film as the adhesive coating layer to the surface of the semiconductor substrate or the support substrate can be adopted.

When the adhesive coating layer is formed from the adhesive composition, heating is performed as necessary.

The heating temperature of the applied adhesive composition varies depending on the type and amount of the adhesive component contained in the adhesive composition, whether or not a solvent is contained, the boiling point of the solvent used, the desired thickness of the adhesive layer, and the like, and thus cannot be generally specified. The heating temperature is usually 80 to 150°C, and the heating time is usually 30 seconds to 5 minutes.

When the adhesive composition contains a solvent, the applied adhesive composition is usually heated.

The heating can be performed using, for example, a hot plate or an oven.

### <Bonding step>

The bonding step is a step of bonding the semiconductor substrate and the support substrate to each other with the adhesive coating layer interposed therebetween. When the laminate has a release layer, the bonding step is a step of bonding the semiconductor substrate and the support substrate to each other with the adhesive coating layer and the release agent coating layer interposed therebetween.

In the bonding step, for example, the semiconductor substrate and the support substrate are bonded via the adhesive coating layer by applying a load in the thickness direction of the semiconductor substrate and the support substrate while performing a heating treatment, a pressure reduction treatment, or both. Which treatment condition of heat treatment, pressure reduction treatment, and combination use of both is adopted is appropriately determined in consideration of various circumstances such as the type of the adhesive composition, the film thickness of the film obtained from the adhesive composition, and the required adhesive strength.

The heat treatment is appropriately determined from the range of usually 20 to 150°C from the viewpoint that when a solvent is contained in the composition, the solvent is removed, the viewpoint that the adhesive coating layer is softened to realize suitable bonding thereof, and the like. In particular, from the viewpoint of suppressing or avoiding excessive curing and unnecessary alteration of the thermosetting components, the heating temperature is preferably 130°C or lower, more preferably 90°C or lower, and the heating time is appropriately determined according to the heating temperature and the type of the adhesive, but from the viewpoint of reliably exhibiting suitable adhesion, the heating time is usually 30 seconds or more, and preferably 1 minute or more, but from the viewpoint of suppressing alteration of the adhesive layer and other members, the heating time is usually 10 minutes or less, and preferably 5 minutes or less.

The pressure reduction treatment may be performed under an atmospheric pressure of 10 to 10,000 Pa. The time for the pressure reduction treatment is usually 1 to 30 minutes.

From the viewpoint of reproducibly obtaining a laminate in which the substrates can be satisfactorily separated, the semiconductor substrate and the support substrate are bonded to each other preferably by pressure reduction treatment, and more preferably by combined use of heat treatment and pressure reduction treatment.

The load in the thickness direction of the semiconductor substrate and the support substrate is not particularly limited as long as the load does not adversely affect the semiconductor substrate, the support substrate, and the layers therebetween and can firmly adhere them, and is usually within the range of 10 to 1,000 N.

### <Adhesive layer-forming step>

The adhesive layer-forming step is a step in which the semiconductor substrate, the adhesive coating layer, and the support substrate are heated to form an adhesive layer from the adhesive coating layer. The heating may be referred to as post-heating.

When the laminate has a release layer, the adhesive layer-forming step is a step in which the semiconductor substrate, the adhesive coating layer, the release agent coating layer, and the support substrate are heated to form an adhesive layer from the adhesive coating layer, and form a release layer from the release agent coating layer.

The temperature for post-heating is preferably 120°C or higher from the viewpoint of achieving a sufficient curing rate, and is preferably 260°C or lower from the viewpoint of preventing deterioration of the substrates and each layer.

The post-heating time is usually 1 minute or more, and preferably 5 minutes or more from the viewpoint of realizing suitable bonding of the substrates and the layers constituting the laminate, and is usually 180 minutes or less, and preferably 120 minutes or less from the viewpoint of suppressing or avoiding an adverse effect on each layer due to excessive heating.

The post-heating can be performed using a hot plate, an oven, or the like.

When post-heating is performed using a hot plate, heating may be performed with either the semiconductor substrate or the support substrate of the laminate facing downward, but it is preferable to perform post-heating with the semiconductor substrate facing downward from the viewpoint of reproducibly realizing suitable peeling. In other words, the heating can be performed from the semiconductor substrate side or the support substrate side, and is preferably performed from the semiconductor substrate side.

It is to be noted that one object of the post-heat treatment is to realize the adhesive layer and the release layer, which are more suitable self-supporting films, and to suitably realize thermosetting of the adhesive coating layer (particularly, curing by a hydrosilylation reaction).

### <Release agent coating layer-forming step>

When the laminate has a release layer, the method for producing a laminate includes a release agent coating layer-forming step.

The release agent coating layer-forming step is a step of forming a release agent coating layer from the release agent composition.

The release agent coating layer may be formed on the semiconductor substrate, on the support substrate, or on the adhesive coating layer.

Examples of the method of forming the release agent coating layer from the release agent composition include a method in which the release agent composition is applied to the surface of the support substrate and heated.

The coating method is not particularly limited, and is usually a spin coating method.

As another method of forming the release agent coating layer from the release agent composition, a method of separately forming a coating film formed from the release agent composition by a spin coating method or the like and attaching the sheet-like coating film as the release agent coating layer to the surface of the semiconductor substrate, the support substrate, or the adhesive coating layer can be adopted.

When the release agent coating layer is formed from the release agent composition, heating is performed as necessary.

The heating temperature of the applied release agent composition varies depending on the type and amount of the acid generator, the boiling point of the solvent to be used, the desired thickness of the release layer, and the like, and thus cannot be generally defined, but the heating temperature is 80°C or higher from the viewpoint of reproducibly realizing a suitable release layer, and is 300°C or lower from the viewpoint of suppressing decomposition of the acid generator and the like, and the heating time thereof is usually appropriately determined in the range of 10 seconds to 10 minutes depending on the heating temperature.

When the release agent composition contains a solvent, the applied release agent composition is usually heated.

The heating can be performed using, for example, a hot plate or an oven.

The film thickness of the release agent coating layer obtained by applying the release agent composition and heating the same as necessary is usually about 5 nm to 100 um, and appropriately determined so as to finally fall within the range of the thickness of the release layer described above.

When the release agent composition is a curable composition, curing may occur when the release agent coating layer is formed from the release agent composition, or curing may occur when the release layer is formed from the release agent coating layer. A part of the curing may occur when the release agent coating layer is formed from the release agent composition, and a part of the curing may also occur when the release layer is formed from the release agent coating layer.

### (Method for producing processed semiconductor substrate)

The method for producing a processed semiconductor substrate of the present invention includes at least a first step and a second step, and further includes other steps such as a third step as necessary.

The first step is a step of processing the semiconductor substrate of the laminate of the present invention.

The second step is a step of separating the semiconductor substrate, which has been processed in the first step, and the support substrate from each other.

The third step is a step of washing the separated semiconductor substrate with a cleaning agent composition.

The processing performed on the semiconductor substrate in the first step is, for example, processing on the opposite side of the circuit surface of the wafer, and includes thinning of the wafer by polishing the back surface of the wafer. Thereafter, a through silicon via (TSV) or the like is formed, and thereafter, the thinned wafer is peeled off from the support substrate to form a laminate of the wafer, and the wafer is three-dimensionally mounted. Before and after that, a wafer back electrode and the like are also formed. In thinning the wafer and in the TSV process, the wafer is applied with heat of about 250 to 350°C in the state of being bonded to the support substrate. In the laminate of the present invention, for example, not only the semiconductor substrate and the support substrate, but also the adhesive layer and the release layer usually has heat resistance to the load.

Note that the processing is not limited to the above-described processing, and includes, for example, implementation of a process of mounting a semiconductor component in a case where a base material for mounting a semiconductor component is temporarily bonded to the support substrate to support the base material.

The second step is not particularly limited as long as it is a step of separating the semiconductor substrate processed in the first step and the support substrate from each other.

For example, the step includes a method of mechanical peeling with a tool having a sharp portion (so-called debonder). Specifically, for example, after the sharp portion is inserted between the semiconductor substrate and the support substrate, the semiconductor substrate and the support substrate are separated.

The method for separating (peeling) the semiconductor substrate and the support substrate in the second step may include peeling between the semiconductor substrate and the support substrate after irradiating the release layer with light.

By irradiating the release layer with light from the support substrate side, the release layer is deteriorated (for example, separation or decomposition of the release layer) as described above, and thereafter, for example, one of the substrates is pulled up, and the semiconductor substrate and the support substrate can be easily separated.

The wavelength of light used for peeling is not particularly limited as long as the light is absorbed by the release layer, but is usually light in a range of 100 to 600 nm, and for example, a suitable wavelength is 308 nm, 343 nm, 355 nm, or 365 nm. The irradiation amount of light necessary for peeling is an irradiation amount that can cause suitable deterioration of the release layer, for example, decomposition.

The light used for peeling may be a laser light or a non-laser light emitted from a light source such as a lamp.

The release layer is not necessarily irradiated with light in the entire region of the release layer. Even if the region irradiated with light and the region not irradiated with light are mixed, the semiconductor substrate and the support substrate can be separated from each other by a slight external force such as pulling up the support substrate, for example, as long as the peeling ability has been sufficiently improved as the entire release layer. The ratio and positional relationship between the region irradiated with light and the region not irradiated with light vary depending on the type and specific composition of the adhesive to be used, the thickness of the adhesive layer, the thickness of the release layer, the intensity of light to be irradiated, and the like, but those skilled in the art can appropriately set the conditions without requiring an excessive test. For such circumstances, according to an example of the method for producing a processed semiconductor substrate of the present invention, for example, it is possible to shorten the light irradiation time when peeling is performed by light irradiation from the support substrate side in a case where the support substrate of the laminate to be used has optical transparency. As a result, in addition to the expectation of improvement in throughput, it is possible to easily and efficiently separate the semiconductor substrate and the support substrate by only light irradiation, while avoiding physical stress and the like for peeling.

Usually, the irradiation amount of light for peeling is 50 to 3,000 mJ/cm². The irradiation time is appropriately determined according to the wavelength and the irradiation amount.

Light irradiation may be performed using laser light, or may be performed using non-laser light from a light source such as an ultraviolet lamp.

In the third step, cleaning is performed by spraying a cleaning agent composition to the surface of the separated semiconductor substrate, or by immersing the separated semiconductor substrate in a cleaning agent composition, and then rinsing and drying are usually performed by using a solvent. Examples of the cleaning agent composition include the following.

The cleaning agent composition usually contains a salt and a solvent.

A suitable example of the cleaning agent composition includes a cleaning agent composition containing a quaternary ammonium salt and a solvent.

The quaternary ammonium salt is composed of a quaternary ammonium cation and an anion, and is not particularly limited as long as it is used for this type of application.

Such quaternary ammonium cations typically include tetra(hydrocarbon)ammonium cations. On the other hand, the anion paired therewith includes a hydroxide ion (OH⁻); halogen ions such as a fluorine ion (F⁻), a chlorine ion (Cl-), a bromine ion (Br-), and an iodine ion (I-); tetrafluoroborate ion (BF₄⁻); hexafluorophosphate ion (PF₆⁻); and the like, but is not limited thereto.

The quaternary ammonium salt is preferably a halogen-containing quaternary ammonium salt, and more preferably a fluorine-containing quaternary ammonium salt.

In the quaternary ammonium salt, the halogen atom may be contained in the cation or in the anion, and is preferably contained in the anion.

In a preferred embodiment, the fluorine-containing quaternary ammonium salt is a fluorinated tetra(hydrocarbon)ammonium.

Specific examples of the hydrocarbon group in the fluorinated tetra(hydrocarbon)ammonium include an alkyl group having 1 to 20 carbon atoms, an alkenyl group having 2 to 20 carbon atoms, an alkynyl group having 2 to 20 carbon atoms, and an aryl group having 6 to 20 carbon atoms.

In a more preferred embodiment, the fluorinated tetra(hydrocarbon)ammonium includes a fluorinated tetraalkylammonium.

Specific examples of the fluorinated tetraalkylammonium include, but are not limited to, fluorinated tetramethylammonium, fluorinated tetraethylammonium, fluorinated tetrapropylammonium, and fluorinated tetrabutylammonium (also referred to as tetrabutylammonium fluoride). Among them, fluorinated tetrabutylammonium is preferable.

As the quaternary ammonium salt such as a fluorinated tetra(hydrocarbon)ammonium, a hydrate may be used. The quaternary ammonium salt such as a fluorinated tetra(hydrocarbon)ammonium may be used singly or in combination of two or more kinds thereof.

The amount of the quaternary ammonium salt is not particularly limited as long as it dissolves in the solvent contained in the cleaning agent composition, and is usually 0.1 to 30 mass% with respect to the cleaning agent composition.

The solvent contained in the cleaning agent composition is not particularly limited as long as it is used for this type of use and dissolves salts such as the quaternary ammonium salt. From the viewpoint of reproducibly obtaining a cleaning agent composition having excellent detergency, from the viewpoint of obtaining a cleaning agent composition having excellent uniformity by favorably dissolving salts such as the quaternary ammonium salt, and the like, the cleaning agent composition preferably contains one or two or more amide-based solvents.

Suitable examples of the amide-based solvent include an acid amide derivative represented by the formula (Z).

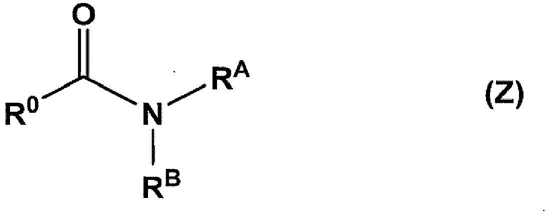

In the formula, R⁰ represents an ethyl group, a propyl group, or an isopropyl group, and is preferably an ethyl group or an isopropyl group, more preferably an ethyl group. R^{A} and R^{B} each independently represent an alkyl group having 1 to 4 carbon atoms. The alkyl group having 1 to 4 carbon atoms may be linear, branched, or cyclic, and specific examples thereof include a methyl group, an ethyl group, a propyl group, an isopropyl group, a cyclopropyl group, a n-butyl group, an isobutyl group, an s-butyl group, a t-butyl group, and a cyclobutyl group. Among them, R^{A} and R^{B} are preferably a methyl group or an ethyl group, more preferably both a methyl group or an ethyl group, and still more preferably both a methyl group.

Examples of the acid amide derivative represented by the formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, and N-ethyl-N-methylisobutyramide. Among them, N,N-dimethylpropionamide and N,N-dimethylisobutyramide are particularly preferable, and N,N-dimethylpropionamide is more preferable.

The acid amide derivative represented by the formula (Z) may be synthesized by a substitution reaction between the corresponding carboxylic acid ester and amine, or a commercially available product may be used.

Another example of the preferred amide-based solvent is a lactam compound represented by the formula (Y).

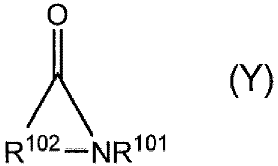

In the formula (Y), R¹⁰¹ represents a hydrogen atom or an alkyl group having 1 to 6 carbon atoms, and R¹⁰² represents an alkylene group having 1 to 6 carbon atoms. Specific examples of the alkyl group having 1 to 6 carbon atoms include a methyl group, an ethyl group, a n-propyl group, and a n-butyl group, and specific examples of the alkylene group having 1 to 6 carbon atoms include a methylene group, an ethylene group, a trimethylene group, a tetramethylene group, a pentamethylene group, and a hexamethylene group, but are not limited thereto.

Specific examples of the lactam compound represented by the formula (Y) include an α-lactam compound, a β-lactam compound, a γ-lactam compound, and a δ-lactam compound, and these compounds can be used alone or in combination of two or more thereof.

In a preferred embodiment, the lactam compound represented by the formula (Y) includes a 1-alkyl-2-pyrrolidone (N-alkyl-γ-butyrolactam), in a more preferred embodiment, N-methylpyrrolidone (NMP) or N-ethylpyrrolidone (NEP), and in a still more preferred embodiment, N-methylpyrrolidone (NMP).

The cleaning agent composition may contain one or two or more other organic solvents different from the above-mentioned amide compound.

Such other organic solvents are not particularly limited as long as they are used for this type of application and are miscible with the above-described amide compound.

Preferred other solvents include an alkyleneglycol dialkylethers, aromatic hydrocarbon compounds, cyclic structure-containing ether compounds, and the like, but are not limited thereto.

The amount of the other organic solvents different from the amide compound described above is usually appropriately determined within 95 mass% or less in the solvent contained in the cleaning agent composition as long as the quaternary ammonium salt contained in the cleaning agent composition is not precipitated or separated, and is uniformly mixed with the amide compound described above.

Incidentally, the cleaning agent composition may contain water as a solvent, but usually, only an organic solvent is intentionally used as a solvent from the viewpoint of avoiding corrosion of the substrate and the like. In this case, it is not denied that hydration water of the salt or water contained in a trace amount in the organic solvent is contained in the cleaning agent composition. The cleaning agent composition usually contains water in an amount of 5 mass% or less.

In the method for producing a processed semiconductor substrate of the present invention, the processed semiconductor substrate produced through the third step has been favorably cleaned with the cleaning agent composition. However, it is not excluded to further clean the surface of the processed semiconductor substrate using a removal tape or the like, and the surface may be further cleaned using a removal tape or the like as necessary.

The constituent elements and method elements related to the above-described steps of the method for producing a processed semiconductor substrate of the present invention may be variously changed without departing from the gist of the present invention.

The method for producing a processed semiconductor substrate of the present invention may include steps other than the above-described steps.

### Examples

Hereinafter, the present invention will be described more specifically with reference to Examples, but the present invention is not limited to the following Examples. The apparatuses used are as follows.

### [Apparatus]

(1) Stirrer: ARE-500, a rotation and revolution mixer manufactured by THINKY CORPORATION
(2) Vacuum bonding apparatus: XBS300; manufactured by SÜSS MicroTec SE.
(3) Thin film stress measurement apparatus: FLX-3300-T; manufactured by Toho Technology Corporation
(4) Optical film thickness meter (film thickness measurement): F-50; manufactured by Filmetrics, INC.

### [1] Preparation of adhesive composition

### [Comparative Example 1]

In a 600 mL stirring vessel dedicated to a rotation and revolution mixer, 54.4 g of a vinyl group-containing MQ resin (manufactured by Wacker Chemie AG) as the polysiloxane (a1), 7.3 g of p-menthane (manufactured by Nippon Terpene Chemicals, Inc.) as a solvent, 3.1 g of propylene glycol 1-monomethyl ether 2-acetate (manufactured by Tokyo Chemical Industry Co., Ltd.) as a second solvent, and 0.22 g of 1,1-diphenyl-2-propyne-1-ol (manufactured by Tokyo Chemical Industry Co., Ltd.) as a crosslinking inhibitor were added, and the resulting mixture was stirred with the rotation and revolution mixer for 5 minutes to obtain a mixture (I).

Into the resulting mixture (I), 8.3 g of a SiH group-containing linear polydimethylsiloxane (manufactured by Wacker Chemie AG) having a viscosity of 100 mPa·s as the polysiloxane (a2) and 24.5 g of a vinyl group-containing linear polydimethylsiloxane (manufactured by Wacker Chemie AG) having a viscosity of 200 mPa·s as the polysiloxane (a1) were added, and the mixture was further stirred for 5 minutes with the rotation and revolution mixer to obtain a mixture (II).

In a 50 mL screw tube, 0.44 g of a platinum catalyst (manufactured by Wacker Chemie AG) as the (A2) and 3.6 g of a vinyl group-containing linear polydimethylsiloxane (manufactured by Wacker Chemie AG) having a viscosity of 1000 mPa·s as the polysiloxane (a1) were stirred for 5 minutes with the rotation and revolution mixer to obtain a mixture (III).

Into the mixture (II), 2.0 g of the mixture (III) was added, and the mixture was further stirred for 5 minutes with the rotation and revolution mixer, and the resulting mixture was filtered through a nylon filter 300 mesh to obtain an adhesive composition. The viscosity of the adhesive composition measured using a rotational viscometer was 700 mPa·s.

### [Example 1]

An adhesive composition was obtained in the same manner as in Comparative Example 1 except that 0.22 g of 1,1-diphenyl-2-propyne-1-ol (manufactured by Tokyo Chemical Industry Co., Ltd.) was changed to 0.22 g of 2,2'-bipyridyl (manufactured by Tokyo Chemical Industry Co., Ltd.) in Comparative Example 1.

### [Example 2]

An adhesive composition was obtained in the same manner as in Comparative Example 1 except that 0.22 g of 1,1-diphenyl-2-propyne-1-ol (manufactured by Tokyo Chemical Industry Co., Ltd.) was changed to 0.22 g of 4,4'-dimethyl-2,2'-bipyridyl (manufactured by Tokyo Chemical Industry Co., Ltd.) in Comparative Example 1.

### [Example 3]

An adhesive composition was obtained in the same manner as in Comparative Example 1 except that 0.22 g of 1,1-diphenyl-2-propyne-1-ol (manufactured by Tokyo Chemical Industry Co., Ltd.) was changed to 0.22 g of 5,5'-dimethyl-2,2'-bipyridyl (manufactured by Tokyo Chemical Industry Co., Ltd.) in Comparative Example 1.

### [Example 4]

An adhesive composition was obtained in the same manner as in Comparative Example 1 except that 0.22 g of 1,1-diphenyl-2-propyne-1-ol (manufactured by Tokyo Chemical Industry Co., Ltd.) was changed to 0.22 g of 4,4'-dinonyl-2,2'-bipyridyl (manufactured by Tokyo Chemical Industry Co., Ltd.) in Comparative Example 1.

The nonyl group of 4,4'-dinonyl-2,2'-bipyridyl is a n-nonyl group.

### [Example 5]

An adhesive composition was obtained in the same manner as in Comparative Example 1 except that 0.22 g of 1,1-diphenyl-2-propyne-1-ol (manufactured by Tokyo Chemical Industry Co., Ltd.) was changed to 0.22 g of tributylphosphine ((CH₃CH₂CH₂CH₂)₃P manufactured by Tokyo Chemical Industry Co., Ltd.) in Comparative Example 1.

### [Example 6]

An adhesive composition was obtained in the same manner as in Comparative Example 1 except that 0.22 g of 1,1-diphenyl-2-propyne-1-ol (manufactured by Tokyo Chemical Industry Co., Ltd.) was changed to 0.22 g of tris(4-methoxyphenyl)phosphine (manufactured by Tokyo Chemical Industry Co., Ltd.) in Comparative Example 1.

### [2] Production of laminate

### [Examples]

The adhesive compositions obtained in Examples 1 to 6 and Comparative Example 1 were spin-coated on a 300 mm silicon wafer (thickness: 775 um) as a device side-substrate, and then heated on a hot plate at 90°C for 90 seconds to form an adhesive coating layer on the silicon wafer as a semiconductor substrate so that the film thickness in the finally obtained laminate was 30 um. On the other hand, a 300 mm silicon wafer (thickness: 775 um) was used as a carrier side-substrate.

Then, using the bonding apparatus, the two silicon wafers were bonded so as to sandwich the adhesive coating layer, and then subjected to post-heating treatment at 200°C for 10 minutes to prepare a laminate. Bonding was performed at a temperature of 23°C and a vacuum degree of 1,500 Pa. The post-heating treatment was performed by heating the bonded laminate from the side of the device side-substrate using a hot plate.

The warpage of the obtained laminate was measured with the thin film stress measurement apparatus. In the measurement of the warpage, the bonded wafer was measured for the height direction displacement of the portion corresponding to the wafer diameter from the notch, and the difference between the maximum value and the minimum value was defined as the warpage value. The height direction on the wafer diameter was measured with a width of 6 mm, and both the ends of 5 mm near the outer periphery were excluded from the measurement range. The measurement results of warpage are shown in Table 1.

**[Table 1]**

| Composition | Crosslinking inhibitor | Warpage [µm] |
|---|---|---|
| Comparative Example 1 | 1,1-diphenyl-2-propyne-1-ol | 531 |
| Example 1 | 2,2'-bipyridyl | 127 |
| Example 2 | 4,4'-dimethyl-2,2'-bipyridyl | 122 |
| Example 3 | 5,5'-dimethyl-2,2'-bipyridyl | 128 |
| Example 4 | 4,4'-dinonyl-2,2'-bipyridyl | 116 |
| Example 5 | Tributylphosphine | 95 |
| Example 6 | Tris(4-methoxyphenyl)phosphine | 117 |

From the results in Table 1, the crosslinking inhibitors used in Examples 1 to 6 showed a result in which the warpage value of the bonded wafer was significantly reduced, compared with the crosslinking inhibitor used in Comparative Example 1. This is presumably because the crosslinking inhibitor controlled the curing rate of the composition, thereby relaxing the stress of the finally obtained laminate.

### Reference Signs List

- 1: Semiconductor substrate
- 2: Adhesive layer
- 3: Support substrate
- 4: Release layer

## Claims

1. A laminate comprising: a semiconductor substrate; a support substrate; and an adhesive layer provided between the semiconductor substrate and the support substrate,
wherein the adhesive layer is formed from a cured product of an adhesive composition,
the adhesive composition contains a polyorganosiloxane that has an alkenyl group having 2 to 40 carbon atoms and bonded to a silicon atom, a polyorganosiloxane having a Si-H group, a platinum group metal-based catalyst, and a crosslinking inhibitor, and
the crosslinking inhibitor contains at least one of a pyridine ring-containing compound and a phosphorus-containing organic compound.

2. The laminate according to claim 1,
wherein the pyridine ring-containing compound contains a compound represented by the following formula (1), and
the phosphorus-containing organic compound contains a compound represented by the following formula (2): 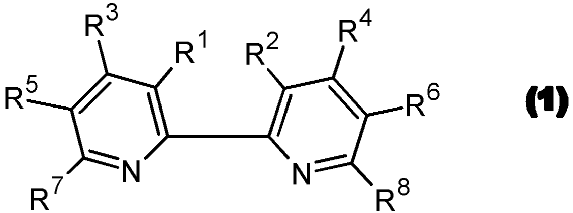
wherein, in the formula (1), R¹ and R² each independently represent a hydrogen atom or an alkyl group optionally having a substituent, or R¹ and R² are combined with each other to form an aromatic hydrocarbon ring that may have an alkyl group optionally having a substituent, or to form -O-; R³ and R⁴ each independently represent a hydrogen atom or an alkyl group optionally having a substituent; R⁵ and R⁶ each independently represent a hydrogen atom or an alkyl group optionally having a substituent; R⁷ and R⁸ each independently represent a hydrogen atom or an alkyl group optionally having a substituent; R⁵ and R⁷, instead of the above definition, may be combined with each other to form an aromatic hydrocarbon ring that may have an alkyl group optionally having a substituent; and R⁶ and R⁸, instead of the above definition, may be combined with each other to form an aromatic hydrocarbon ring that may have an alkyl group optionally having a substituent; 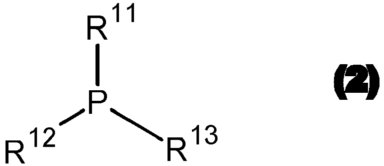
wherein, in the formula (2), R¹¹ to R¹³ each independently represent a hydrocarbon group optionally having a substituent.

3. The laminate according to claim 2, wherein the crosslinking inhibitor contains a compound represented by the formula (1).

4. The laminate according to claim 2, wherein, in the formula (1), R¹, R², R⁷, and R⁸ each represent a hydrogen atom, and R³ to R⁶ each independently represent a hydrogen atom or an alkyl group.

5. The laminate according to claim 2, wherein, in the formula (1), the alkyl groups each independently have 1 to 12 carbon atoms.

6. The laminate according to claim 2, wherein the crosslinking inhibitor contains a compound represented by the formula (2).

7. The laminate according to claim 2, wherein, in the formula (2), R¹¹ to R¹³ each independently represent an alkyl group optionally having a substituent or a phenyl group optionally having a substituent.

8. The laminate according to claim 7, wherein, in the formula (2), the alkyl groups each independently have 1 to 12 carbon atoms.

9. A method for producing a processed semiconductor substrate, the method comprising:
a first step of processing the semiconductor substrate of the laminate according to any one of claims 1 to 8; and
a second step of separating the semiconductor substrate, which has been processed in the first step, and the support substrate from each other.

10. An adhesive composition to be used, in a laminate having: a semiconductor substrate; a support substrate; and an adhesive layer provided between the semiconductor substrate and the support substrate, to form the adhesive layer,
the composition comprising: a polyorganosiloxane that has an alkenyl group having 2 to 40 carbon atoms and bonded to a silicon atom, a polyorganosiloxane having a Si-H group, a platinum group metal-based catalyst, and a crosslinking inhibitor, wherein
the crosslinking inhibitor contains at least one of a pyridine ring-containing compound and a phosphorus-containing organic compound.

11. The adhesive composition according to claim 10,
wherein the pyridine ring-containing compound contains a compound represented by the following formula (1), and
the phosphorus-containing organic compound contains a compound represented by the following formula (2): 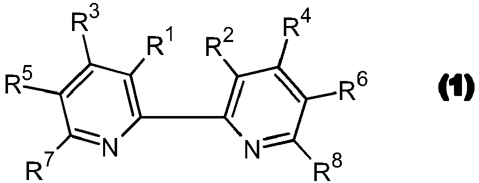
wherein, in the formula (1), R¹ and R² each independently represent a hydrogen atom or an alkyl group optionally having a substituent, or R¹ and R² are combined with each other to form an aromatic hydrocarbon ring that may have an alkyl group optionally having a substituent, or to form -O-; R³ and R⁴ each independently represent a hydrogen atom or an alkyl group optionally having a substituent; R⁵ and R⁶ each independently represent a hydrogen atom or an alkyl group optionally having a substituent; R⁷ and R⁸ each independently represent a hydrogen atom or an alkyl group optionally having a substituent; R⁵ and R⁷, instead of the above definition, may be combined with each other to form an aromatic hydrocarbon ring that may have an alkyl group optionally having a substituent; and R⁶ and R⁸, instead of the above definition, may be combined with each other to form an aromatic hydrocarbon ring that may have an alkyl group optionally having a substituent; 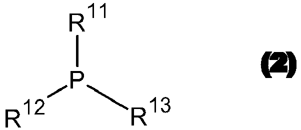
wherein, in the formula (2), R¹¹ to R¹³ each independently represent a hydrocarbon group optionally having a substituent.

12. The adhesive composition according to claim 11, wherein the crosslinking inhibitor contains a compound represented by the formula (1).

13. The adhesive composition according to claim 11, wherein, in the formula (1), R¹, R², R⁷, and R⁸ each represent a hydrogen atom, and R³ to R⁶ each independently represent a hydrogen atom or an alkyl group.

14. The adhesive composition according to claim 11, wherein, in the formula (1), the alkyl groups each independently have 1 to 12 carbon atoms.

15. The adhesive composition according to claim 11, wherein the crosslinking inhibitor contains a compound represented by the formula (2).

16. The adhesive composition according to claim 11,
wherein, in the formula (2), R¹¹ to R¹³ each independently represent an alkyl group optionally having a substituent or a phenyl group optionally having a substituent.

17. The adhesive composition according to claim 16, wherein, in the formula (2), the alkyl groups each independently have 1 to 12 carbon atoms.

18. A method for producing a laminate, the method comprising:
a step of applying the adhesive composition according to any one of claims 10 to 17 on a semiconductor substrate or on a support substrate to form an adhesive coating layer;
a step of bonding the semiconductor substrate and the support substrate to each other through the adhesive coating layer; and
a step of heating the semiconductor substrate, the adhesive coating layer, and the support substrate to form an adhesive layer from the adhesive coating layer.

19. The method for producing a laminate according to claim 18, wherein the heating is performed from a side of the semiconductor substrate or a side of the support substrate.
